# EUROPEAN PATENT SPECIFICATION

(11) **EP 2 494 618 B1**
(45) Date of publication and mention of the grant of the patent: **03.10.2018**
(21) Application number: 10773205.9
(22) Date of filing: 22.10.2010
(51) Int. Cl.: H01L 51/52

(54) **ACTIVE MATRIX ELECTROLUMINESCENT DISPLAY WITH SEGMENTED ELECTRODE**
ELEKTROLUMINESZENTE AKTIVMATRIXANZEIGE MIT SEGMENTIERTER ELEKTRODE
DISPOSITIF D'AFFICHAGE ÉLECTROLUMINESCENT À MATRICE ACTIVE ÉQUIPÉ D'UNE ÉLECTRODE SEGMENTÉE

(30) Priority: 29.10.2009 US 608049
(43) Date of publication of application: 05.09.2012
(73) Proprietor: Global OLED Technology LLC, Herndon, VA 20171 (US)
(72) Inventor: HAMER, John, W., Rochester, NY 14650 (US); MILLER, Michael, E., Rochester, NY 14650 (US)
(74) Representative: Gunzelmann, Rainer
(86) International application number: PCT/US2010/053711
(87) International publication number: WO 2011/059663

(56) References cited:
- EP-A1- 0 978 880
- EP-A2- 1 315 208
- US-A- 5 982 345
- US-A1- 2005 057 176

## Description

### FIELD OF THE INVENTION

The present invention relates to an active matrix electroluminescent (EL) display having a segmented top electrode wherein the electrode segments are driven to provide an increased resolution. Several applications of this EL display are discussed, including a reduced power EL display, a stereoscopic EL display, a high resolution EL display, and a multi-view EL display.

### BACKGROUND OF THE INVENTION

Electroluminescent (EL) displays are known in the art, which include one or more layers of EL material, including a light-emitting layer located between two electrodes, all of which are coated onto a display substrate. These EL displays often include organic electroluminescent displays in which the EL material includes organic molecules. In these displays, at least one of the electrodes is segmented such that the segments overlapping regions of the two electrodes form two-dimensional islands, with each overlapping island defining an individual light-emitting element.

EL displays are classified as either passive-matrix or active-matrix displays. In passive-matrix displays, each of the electrodes are patterned into strips wherein the strips of the electrode serving as the anode and the strips of the electrode serving as the cathode are orthogonal to each other. In this way, the overlap between the two electrodes forms regions that are isolated from one another, or light-emitting elements. By addressing both the cathode and the anode with individual electrical signals, distinct currents are provided to the individual light-emitting elements to control the light output of each light-emitting element. However, to avoid cross talk and to provide distinct currents to each light-emitting element, current can only be provided to one electrode strip, typically the cathode, within one direction, typically the row direction, at any instant in time. Because each light-emitting element preferably produces light at least 60 times per second to avoid flicker, and because each light-emitting element has a very significant capacitance, significant power losses occur if the passive-matrix display is large or high in resolution. Therefore, passive matrix EL displays are often only practical when forming small or low resolution displays. These displays, however, have the advantage that they do not require an active circuit for controlling the current to each light-emitting element.

One example of a passive-matrix EL display is provided by Liedenbaum et al. in U.S. Patent No. 6,927,542. As shown in this patent, each of the electrodes are formed from a one-dimensional array of stripes and the stripes forming the anode and cathode are orthogonal to one another to define individual light-emitting elements. Also discussed in this patent are drivers for driving (i.e., providing a drive voltage or current) to the electrodes. As discussed, each driver provides a signal to a stripe of each electrode, each stripe corresponding to multiple light-emitting elements. As this patent demonstrates, the drivers are arranged so that any circuit sequentially provides a signal to multiple electrode stripes.

In another example of a passive-matrix display, Komatsu et al in U.S. Patent No. 6,791,260, discusses a passive matrix EL display which is divided into two regions with each region having its own group of active row and column electrodes. This arrangement permits two rows of light-emitting elements to be simultaneously addressed and therefore increases the practical resolution of a passive-matrix EL display. However, it is not possible to independently control the current to every element of either electrode through active circuits and therefore Komatsu et al clearly provides a passive matrix display.

Active-matrix EL displays, are formed by patterning only one of the electrodes, typically the anode, into a two-dimensional array of islands which define the light-emitting elements. The counter-electrode is then blanket coated to cover all of the patterned electrodes in both dimensions. An active matrix circuit is attached to each of the light-emitting elements within the patterned electrode and controls the current to each light-emitting element. This active matrix circuit typically includes at least a power transistor for controlling the flow of current from a metal bus to an island of the patterned electrode, a capacitor for controlling the gate voltage of the power transistor, and a second transistor to permit the selection of a capacitor to permit a drive voltage to be loaded onto the capacitor. An active matrix circuit for use with an EL display has been discussed by Cok in U.S. Patent No. 6,636,191.

Displays employing high resolution arrays of these active matrix drive circuits are complex to make and the active matrix circuits typically require significant space on the display substrate. For this reason, the resolution of the active-matrix EL display is typically constrained by the number of active matrix circuits that are formed on the display substrate. Much larger and higher resolution devices are formed with this technology than is possible with a passive-matrix EL display, but the resolution is often less than is required for many applications. Further, defects are likely when forming the hundreds of thousands or millions of transistors that are required to form such a display and the likelihood of a defect increases with increasing numbers of transistors. Therefore, increasing the resolution of the display by increasing the number of active-matrix circuits typically results in lower yields of marketable displays from manufacturing and, therefore, increases the manufacturing cost of the display. It is therefore, desirable to increase the resolution of the display, without increasing the number of transistors that are required.

There are many applications in which very high resolution EL displays are particularly desirable. One application is the creation of auto-stereoscopic and especially multi-view auto-stereoscopic displays. Within this application area, it is known to apply barriers, lenses, or other structures to direct the light from some light-emitting elements within a display to one point or angular subtense in space while directing the light from other light-emitting elements within the display to a different point or angular subtense in space. Through this method, light from two different light-emitting elements within the display are provided to each of a user's eyes to provide an auto-stereoscopic image or to different users viewing the display within an environment. Unfortunately, the resolution of each image is reduced by a factor equal to the inverse of the number of different directions and therefore, these methods reduce the effective resolution of the display device. For example, Chou et al in "A Novel 2-D/3-D Arbitrarily Switchable Autostereoscopic Display" SID 09 Digest pgs. 1407-1410 discusses a display capable of providing a traditional two-dimensional image with a 1280 by 800 addressable pixels. This display an also be switched to provide a four-view multi-view stereo display. However, when displaying the four-view, multiview stereo image the display has only 960 by 266 addressable pixels. Therefore, to provide a high resolution image, the resolution is increased such that the number of light-emitting elements is equal to the number of light-emitting elements within a traditional two-dimensional display, multiplied by the number of different directions that are required. Therefore, to produce a display having four views as described by Chou at the resolutions that are typical for 2D displays, would require forming a display with four times the number of transistors as a typical 2D display. Similarly lenticular lens arrays or addressable liquid crystal lenses with similar properties are known for the creation of stereoscopic displays as discussed by Kao et al. in "An auto-stereoscopic 3D Display using Tunable Liquid Crystal Lens Array that Mimics Effects of GRIN Lenticular Lens Array" SID09 Digest pgs. 111-114. As with barrier screens, these type of screens reduce the effective resolution of the display when presenting multi-view stereo images.

Stereoscopic displays have also been discussed which divide the temporal domain to provide multiple images. For example, Huang et al., in "High resolution autostereoscopic 3D display with scanning multi-electrode driving liquid crystal (MeD-LC) Lens" (Society for Information Display 2009 (SID'09) Proceedings, pgs. 336-339) describe a display concept in which an addressable lens is formed over a display and the shape of the lens is modified with time to direct the image from any light-emitting diode to multiple locations in space. This method requires the image on the display to be updated at a rate of at least 60 times the number of views to avoid flicker and further requires an optical lens that is accurately modified a the same update rate. Furthermore, the lens requires multiple electrodes for each pixel. Therefore, this approach can be expensive to implement, and can require a lower-resolution display to achieve acceptable update rates. Unfortunately, display technologies that are commercially available today have limited update rates, which would limit the number of views provided by such a method.

Another known application in which very high resolution EL displays are particularly desirable is to provide a low power display through viewing angle reduction. For example, Lee, in U.S. Patent Application Publication No. 2007/0091037 A1, discusses the use of a sparse array of microlenses together with a much higher density array of light-emitting elements to steer light to the eyes of a user. As such, different light-emitting elements are selected to steer the light to the eyes of the user, such that the user can perceive the display as having a very large field of view, even though the display only provides a small field of view at any moment. This ability to selectively adjust the field of view of the display permits the power consumption of the display to be reduced by significant amounts by reducing the field of view of the display, while providing the user with a perceptually wide field of view. Unfortunately, such a display requires a large number of individually-addressable light-emitting elements within each pixel. Moreover, with the technology available today, it is not possible to create a high-resolution display having numerous, individually-addressable light-emitting elements within each pixel. Although Lee is not specific to the type of microlenses that are applied, these microlenses can include lenticular lenses as taught by Tutt et al., in U.S. Patent No. 6,570,324.

Reference is likewise made to the prior art documents US5982345 and US2005057176. There is, therefore, a need for providing an EL display having a very high resolution. Particularly, there is a need for an active-matrix EL display having a larger number of individually-addressable light-emitting elements than the number of active-matrix circuits.

### SUMMARY OF THE INVENTION

In accordance with the present invention there is provided an active-matrix electroluminescent according to the independent device claim 1.

The arrangement of the present invention provides the advantages of improving the effective resolution of the active-matrix electroluminescent display, without increasing the number of active matrix drive circuits within the display. Additionally, this arrangement can be provided with optical lenses to reduce the power consumption of the display or provide sets of image data.

### BRIEF DESCRIPTION OF THE DRAWINGS

FIG. 1 a cross section of a portion of an active matrix display panel useful in an active matrix EL display of the present invention;
FIG. 2 a schematic of an active matrix circuit useful in an active matrix EL display of the present invention;
FIG. 3 a schematic of an active matrix electroluminescent display of the present invention;
FIG. 4 a top view of a portion of an active matrix display panel useful in an active matrix EL display of the present invention;
FIG. 5 a flow chart of a method useful in driving an active matrix EL display of the present invention;
FIG. 6 a schematic of an active matrix circuit useful in an active matrix EL display of the present invention;
FIG. 7 a top view of a portion of an active matrix display panel employing chiplets to provide active matrix circuits in an arrangement of the present invention;
FIG. 8 a cross section of a portion of a display panel including an optical layer according to an arrangement of the present invention;
FIG. 9 a top view of a portion of a display panel including an optical layer according to an arrangement of the present invention; and
FIG. 10 a cross section of a portion of a display panel including an optical layer according to an arrangement of the present invention.

### DETAILED DESCRIPTION OF THE INVENTION

The present invention provides an electroluminescent (EL) display having a larger number of individually-addressable light-emitting elements than the number of active-matrix circuits for providing current to each individual light-emitting element.

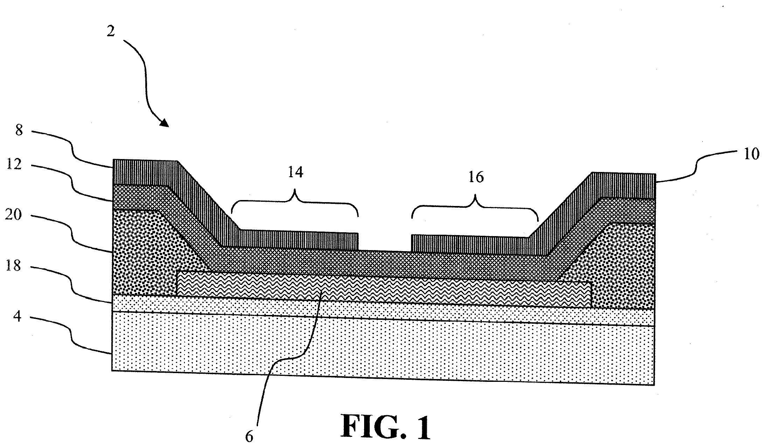

The present invention provides an active-matrix electroluminescent display. This active-matrix electroluminescent display includes a display panel 2, a portion of which is shown in FIG. 1. This display panel 2 includes a display substrate 4. At least a first electrode 6 is disposed over an area of the display substrate 4. Two or more individually-addressable, second electrodes 8, 10 are further disposed over the display substrate 4 and the first electrode 6. An electroluminescent light-emitting layer 12 is formed between and in electrical contact with the first 6 and each of the second 8, 10 electrodes, so that first and second active areas 14, 16 are defined where the first electrode 6 and each respective second electrode 8, 10 overlap. The light-emitting layer 12 emits light within each active area 14, 16 in response to current between the first 6 and each respective second electrode 8, 10. Also shown in FIG. 1, the display panel 2 can optionally include an active matrix layer 18 and additional layers such as the pixel definition layer 20.

Within arrangements of the present invention, an "active area"14, 16 is an area in which a discrete element of the first electrode 6, a portion of the light-emitting layer 12, and a discrete element of the second electrode 8 or 10 overlap and are in electrical contact with each other such that the portion of the light-emitting layer 12 within the active area 14, 16 emits light in response to the flow of current between the first electrode 6 and one of the second electrodes 8 or 10. Within this definition, it is understood that any two discrete elements of the first electrode will be electrically isolated from one another and the voltage to any discrete element of first electrode is controlled independently of any other first electrode. Further, any two discrete elements of the second electrode overlapping a first electrode will be electrically isolated from one another and the voltage to any discrete element of second electrode overlapping the first electrode is controlled independently of the voltage to any other discrete element of the second electrode overlapping the first electrode. It should be noted that this definition requires second electrodes corresponding to, or overlapping, a first electrode to be electrically isolated from one another and to supply a voltage that is independently controllable. However, second electrodes corresponding to, or overlapping, two separate first electrodes can, but are not required to, be electrically isolated from each other or to be independently controllable.

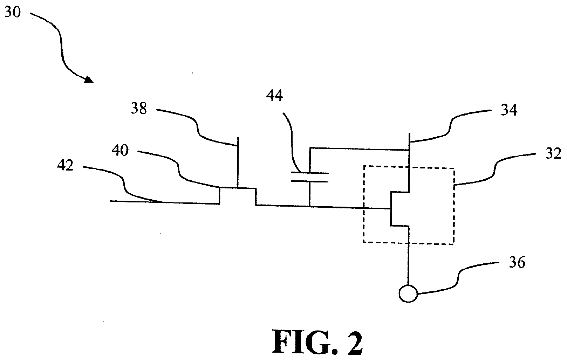

A drive circuit, such as the drive circuit 30 shown in FIG. 2 is also included in the EL display of the present invention. For example, the drive circuit 30 of FIG. 2 is formed within the active matrix layer 18 of FIG. 1. As shown in FIG. 2, this drive circuit 30 will include a drive transistor 32. The drive transistor 32 is a part of an active circuit for modulating the flow of current from a power line 34 through the first electrode 6 of FIG. 1, indicated by the node 36 in FIG. 2. As such the drive circuit 30 controls the flow of current through the electroluminescent light-emitting layer 12 (shown in FIG. 1). The drive circuit 30 will typically include the other components of FIG. 2, including a select line 38 for providing a signal to open the gate on a data transistor 40, permitting a control signal to be provided to the drive circuit 30 over the data line 42. This control signal is stored in a capacitor 44. This control signal will control the gate of the drive transistor 32 to control the flow of current between the power line 34 and the node 36 representing the first electrode.

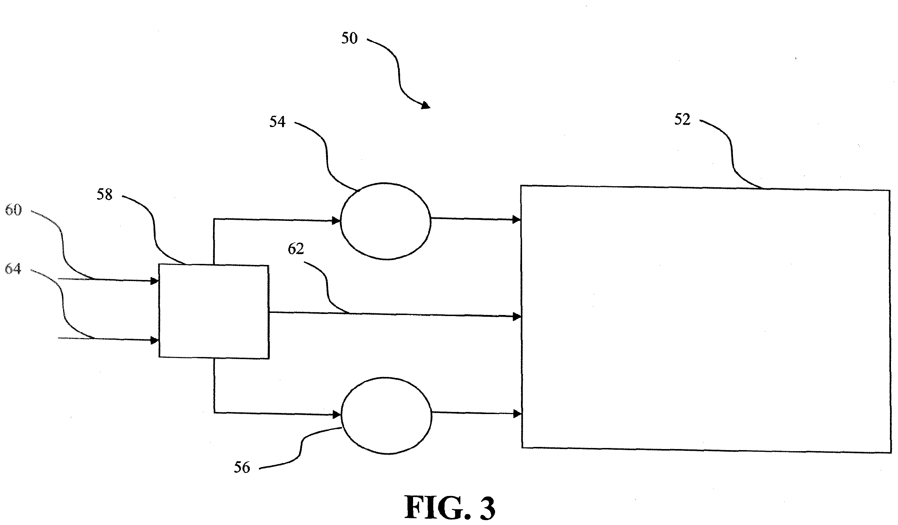

An active matrix EL display 50 of the present invention further includes two power supply circuits 54, 56 as depicted in FIG. 3. FIG. 3 shows that the power supply circuits 54, 56 are each connected to a display panel 52, a portion of which is depicted in FIG.1. However, these power supply circuits 54, 56 are each specifically connected to the respective second electrodes 8, 10 (as shown in FIG. 1) for selectively providing respective voltages to the respective second electrodes 8, 10. A controller 58 is further included for sequentially or simultaneously causing the power supply circuits 54, 56 to provide the voltages to the respective second electrodes 8, 10.

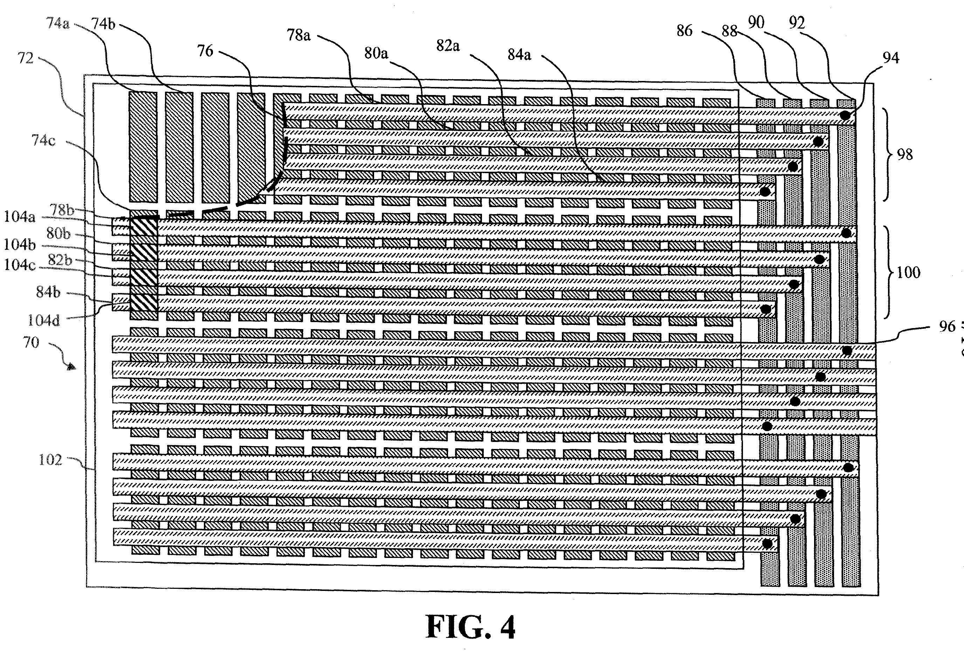

A particularly desirable arrangement of the first 6 and second electrodes 8, 10 within a display panel 70 of an active-matrix electroluminescent display 50 (shown in FIG. 3) of the present invention is shown in FIG. 4. As shown in FIG. 4, display panel 70 within the active-matrix electroluminescent display further includes a two-dimensional array of first electrodes 74a, 74b, 74c disposed over a display substrate 72 where 74a and 74b are arranged along a first dimension of the two-dimensional array and 74a and 74c are arranged along a second dimension of the two-dimensional array. To improve the visibility of these first electrodes 74a, 74b, 74c, a cutout 76 through second electrodes 78a, 80a, 82a, 84a is provided within this figure. Within the arrangement shown in FIG. 4, a one-dimensional array of second electrodes 78a, 80a, 82a, 84a is provided. Each of the second electrodes 78a, 80a, 82a, and 84a overlaps a plurality of first electrodes. For example, without the cutout 76, second electrodes 78a, 80a, 82a, and 84a overlap first electrodes 74a and 74b as well as all other first electrodes along the first dimension. In this arrangement, two or more second electrodes 78b, 80b, 82b, 84b are disposed over each of the first electrodes 74c within the two dimensional array of first electrodes. An electroluminescent light-emitting layer 102 is formed between and in electrical contact with the both the first electrodes 74c in the array of first electrodes and the second electrodes 78b, 80b, 82b, 84b within active areas 104a, 104b, 104c, 104d, the light-emitting layer 102 emitting light from each active area areas 104a, 104b, 104c, 104d in response to a current between one of the first electrodes 74c in the two dimensional array of first electrodes and one of the two or more second electrodes 78b, 80b, 82b, 84b that are disposed over the first electrode 74c. As shown, each second electrode 78b, 80b, 82b, 84b within the active matrix EL panel extends in a first direction, and includes a two-dimensional array of first electrodes 74a, 74b, 74c disposed over the display substrate 72 and a one-dimensional array of second electrodes wherein each of the second electrodes 78b, 80b, 82b, 84b overlaps a plurality of first electrodes 74a, 74b.

An "array" of the present invention includes a plurality of similar structures arranged in an ordered pattern. A one-dimensional array includes a plurality of structures arranged along a first dimension and a singular structure arranged along a second dimension, wherein the second dimension is typically perpendicular to the first dimension. A two-dimensional array includes a plurality of structures arranged along a first dimension and a plurality of structures arranged along a second dimension, wherein the second dimension is typically perpendicular to the first dimension.

In the arrangement shown in FIG. 3, the second electrodes 78a, 80b, 82c, 84c, which overlap the first electrodes 74a, 74b along a first dimension define a group of second electrodes 98. Other groups of second electrodes are formed by second electrodes, which overlap each of the one-dimensional arrays of first electrodes within the first dimension. For example, group of second electrodes 100 is formed by electrodes 78b, 80b, 82b, 84b that overlap first electrode 74c as well as the other first electrodes arranged along the first dimension with first electrode 74c. As shown in this figure, each group of second electrodes 98, 100 has an equal number of second electrodes and each group includes a corresponding first second electrode 78a, 78b and second, second electrode 80a, 80b. These corresponding electrodes 78a, 78b and 80a, 80b are electrically connected to each other. As shown in FIG. 4, power busses 86, 88, 90, 92 are provided on the EL panel 70 and are electrically isolated from most of the second electrodes 78a, 78b, 80a, 80b, 82a, 82b, 84a, 84b by an insulating layer (not shown). However, these power busses 86, 88, 90, 92 are connected to selected second electrodes 78a, 78b, 80a, 80b, 82a, 82b, 84a, 84b through vias, including via 94 which connects power buss 92 to second electrode 78a. Notice that the power buss 92 is connected to second electrode 78a within the group of second electrodes 98 and to the corresponding second electrode 78b within a different group of second electrodes 100. As such, corresponding second electrodes within each group are electrically connected to one another. Further, power leads such as power lead 96 are formed to buss power to the edge of the EL panel 70 to permit connection of each of the power busses 86, 88, 90, 92 and to one of the power supply circuits, for example power supply circuit 54 or 56 (shown in FIG. 3). Within this arrangement, a plurality of identical groups of second electrodes is formed, with each group overlapping a plurality of corresponding first electrodes arranged along the first direction. In this arrangement, each second electrode within each group of second electrodes is electrically connected to corresponding second electrodes within each group of second electrodes and to a different power supply circuit.

Within this arrangement, the power busses 86, 88, 90, 92 will preferably be formed from a metal, for example a metal layer used to form TFTs within the active matrix layer 18 (shown in FIG. 1) and the power busses 86, 88, 90, 92 are insulated from the second electrodes 78a, 78b, 80a, 80b, 82a, 82b, 84a, 84b by a portion of the layer that is used to form the pixel definition layer 20 (shown in FIG. 1). Such an arrangement is particularly desirable as it requires a small number of power supply circuits 54, 56, typically less than or equal to the number of second electrodes within each group of second electrodes. In desirable arrangements, the number of second electrodes 78a, 80a, 82a, 84a and therefore the number of power supply circuits 54, 56 within each group of second electrodes 98 will typically be between 2 and 50 and more preferably between 5 and 30. Further this arrangement requires a small number of connections to the second electrodes 78a, 78b, 80a, 80b, 82a, 82b, 84a, 84b, which permits a relatively simple and cost effective solution for providing the benefits of the present invention.

Further discussing the elements of FIG. 3, the power supply circuits 54, 56 will typically include switches for switching among or between small numbers of voltage levels. For example the power supply circuits 54, 56 can, in one arrangement, switch between power supply circuits to provide two different voltages, one voltage corresponding to a reference voltage that provides a large enough electrical potential with respect to the first electrodes to permit current to flow through the light-emitting layer and a second voltage that provides a small enough electrical potential with respect to the first electrodes that current can not flow through the light-emitting layer. That is, the voltage potential between the first and second electrodes will be below the threshold for light emission from the light-emitting layer or a reverse bias will be applied to the light-emitting layer. In this arrangement the controller 58 can switch between these two voltage levels to sequentially or simultaneously cause the power supply circuits 54, 56 to provide the voltage to the respective second electrodes such as to simultaneously cause the power supply circuits 54, 56 to simultaneously provide different voltages to the respective second electrodes. Notice that in this example, when the switch is set such that the voltage provides a large enough electrical potential with respect to the first electrodes to permit current to flow through the light-emitting layer, the light-emitting layer will be capable of emitting light within the active areas that are defined by the overlap of the second electrodes with the first electrodes and the light-emitting layers as long as an appropriate signal is provided to the first light-emitting layer. However, when the voltage is switched, the light-emitting layer will be not be capable of emitting light within the active areas that are defined by the overlap of the second electrodes with the first electrodes and the light-emitting layers, for any signal that is provided by the drive circuit 30 (shown in FIG. 2) to the first electrodes. It is also possible for the power supply circuits 54, 56 to switch between more than two voltages, for example, it is desirable for the power supply circuits 54, 56 to switch to a third voltage corresponding to provide a second reference voltage that permits a step change in the flow of current through the light-emitting layer. It is particularly desirable to select this third voltage to permit a current to flow through the light-emitting layer that is approximately equal to the current that flows in response to the first voltage divided by the number of second electrodes within each group of second electrodes.

In another arrangement, the power supply circuits 54, 56 permit the second electrodes to be connected to a voltage source or simply disconnecting the second electrodes from the voltage source, permitting the voltage of the second electrodes to float. In this arrangement, the controller 58 for sequentially or simultaneously causing the power supply circuits to provide the voltage to the respective second electrodes can simultaneously cause the power supply circuits to provide a first voltage to one of the second electrodes while simultaneously disconnecting the other second electrode, permitting the second electrode to float. Once again, it is worth noting that when the second electrodes are connected to the voltage source the voltage source will provide a large enough electrical potential with respect to the first electrodes to permit current to flow through the light-emitting layer. Therefore, the light-emitting layer will be capable of emitting light within the active areas that are defined by the overlap of the second electrodes with the first electrodes and the light-emitting layers as long as an appropriate signal is provided to the first light-emitting layer. However, disconnected from the voltage source, the light-emitting layer will be not be capable of emitting light within the active areas that are defined by the overlap of the second electrodes with the first electrodes and the light-emitting layers, for any signal that is provided by the drive circuit 30 (shown in FIG. 2) to the first electrodes.

In each of these examples, the power supply circuits 54, 56 are capable of providing a switch between at least two conditions, one permitting light emission from the active areas 14, 16 of the light-emitting layer 12 (depicted in FIG. 1) which correspond to the second electrodes 8, 10 to which the power supply circuit 54, 56 is attached and a second which precludes light emission from the active areas 14, 16 of the light-emitting layer 12 (depicted in FIG. 1) which correspond to the second electrodes 8, 10 to which the power supply circuit 54, 56 is attached. Further notice that this activation/deactivation switch is provided regardless of the state of the drive circuit 30 or the signal that it provides to the first electrode 6 (as shown in FIG. 1). Therefore, the active areas will be defined to be "activated" when the switch is set to provide a voltage to permit light emission and "deactivated" when the switch is set to provide a voltage to prevent light emission.

In display applications, it is further desirable that the controller 58 additionally receives an input image signal 60 and provides a first drive signal 62 to the drive circuit synchronously with causing the power supply circuits 54, 56 to provide the voltage to the respective second electrodes 8, 10 (shown in FIG. 1). In this way, the controller 58 provides a drive signal 62 to the drive circuit 30 (shown in FIG. 2), which will typically provide analog control of the current through an active area 14, 16 when the controller 58 provides a signal to the power supply circuits 54, 56 to activate the active areas. However, the controller 58 can alternatively provide a signal to the power supply circuits 54, 56 to deactivate the active areas.

It is desirable then that under some conditions, the controller 58 will provide a signal to at least a first power supply circuit of the power supply circuits 54, 56 to provide an activation signal while providing a signal to at least a second power supply circuit, different from the first power supply circuit, to provide a deactivation signal. As such, a portion of the active areas, specifically the active areas in electrical contact with the second electrodes attached to the first power supply circuit, will emit light in response to a signal provided to the first electrode by the drive circuit while a second portion of the active areas, specifically the active areas in electrical contact with the second electrodes attached to the second power supply circuit, will not emit light. Referring to FIG. 4, such a selection will permit the active areas corresponding to one or more of the corresponding second electrodes, for example 78a and 78b, within each group of second electrodes 98, 100 to emit light in response to the signal provided by the drive circuit 30 (shown in FIG.2) while other active areas corresponding to one or more of the other corresponding second electrodes 80a, 80b, 82a, 82b, 84a, 84b within each group of second electrodes 98, 100 will not emit light in response to the signal provided by the drive circuit 30 (shown in FIG.2).

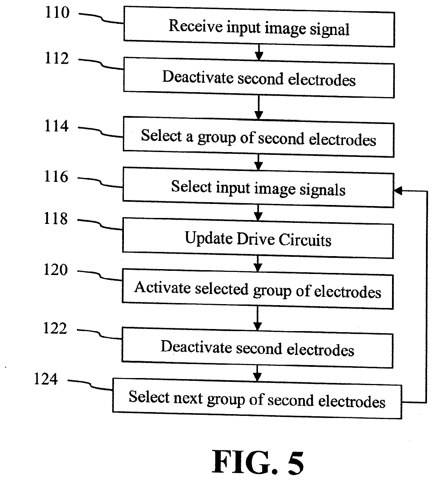

By employing the active matrix EL display as described, an active matrix EL display is provided having a larger number of individually-addressable light-emitting elements than the number of active-matrix circuits for providing current to individual light-emitting elements. To provide such a display, the controller 58 in FIG. 3 can employ the process shown in FIG. 5. As provided in FIG. 5, the controller receives 110 the input image signal 60 having a resolution equal to the number of first electrodes multiplied by the number of second electrodes within each group or receives a signal and applies spatial scaling technology to provide a signal having this resolution. This input image signal 60 will provide an image signal for displaying a first image on the display. In the display panel 70 shown in FIG. 4 having 17 first electrodes, including 74a, 74b along a first dimension and 4 first electrodes, including 74a, 74c along a second dimension and four second electrodes in each group, the input image signal will preferably include signals for 68 unique pixels, e.g., 17 columns by 16 rows, where the 16 rows include 4 rows formed by the first electrode and wherein each of these 4 rows are divided into 4 rows by the second electrodes within each group of second electrodes. The second electrodes are deactivated 112 and a respective second electrode within each group is selected for activation 114. The subset of the input image signals to a first subset of the image data which corresponds to the respective second electrode within each group, is then selected 116. The controller 58 then updates 118 the drive signals by providing the drive signal 62 to the drive circuit 30 (shown in FIG. 2) connected each of the first electrodes, wherein this drive signal corresponds to the first subset of the image data. The controller 58 then provides a signal to a power supply circuit 54, 56, wherein the power supply circuit provides a voltage to the second electrodes selected in step 114 to activate 120 the corresponding active areas of the display. As such, one active area within the area defined by one of the first electrodes is illuminated and has a light output that corresponds to the first subset of the first image data that were selected in step 116. As such, in this example every fourth line of data in the input image signal is provided within one of the active areas of each first electrode. The controller 58 then provides a signal to the power supply circuit corresponding to the active second electrodes to deactivate 122 the active areas in correspondence with these second electrodes, stopping emission of the light. The controller then selects 124 a second subset of image data and a second subset of second electrodes and repeats steps 116 through 122. When this process is completed at a rate such that every active area is activated in response to a unique input image signal with a frequency of at least 60 Hz, the user perceives an image having a resolution equal to the number of first electrodes multiplied by the number of second electrodes within each group. By applying the method of FIG. 5, the controller sequentially provides a first subset of the input image signal to the drive circuit while causing the power supply circuits to activate a first subset of second electrodes to produce first light during a first time interval and provides a second subset of the input image signal to the drive circuit while causing the power supply circuits to activate a second subset of second electrodes to produce second light during a second time interval, whereby a user sees a high resolution display. This high resolution display will have a larger number of perceived light-emitting elements than the number of drive circuits in the display as the light from each active area will be integrated by the human eye and therefore, the display will have a perceived resolution that is greater than the resolution of a display of the prior art having an equal number of drive circuits.

In the display panel arrangement as shown in FIG. 4 wherein multiple rows of the display are activated, it is desirable for the drive circuit 30 in FIG. 2 to receive and store the first drive signal during a first display update cycle and provide the signal to the first electrode element during a second display update cycle. In fact, if the drive circuit 30 can receive and store at least as many values as there are groups of second electrodes, the rate at which data is loaded into the drive circuit 30 is significantly reduced. To achieve this, the drive circuit 30 is modified to store multiple values and to provide a signal to the first electrode for each of these multiple values. Within this arrangement, the term "update cycle" refers to the process providing a data signal to each drive circuit 30 within the active-matrix EL display. An update cycle is completed once each of the drive circuits 30 in the active matrix EL display has been updated or written to the storage element or capacitor 44 of the drive circuit 30 exactly one time.

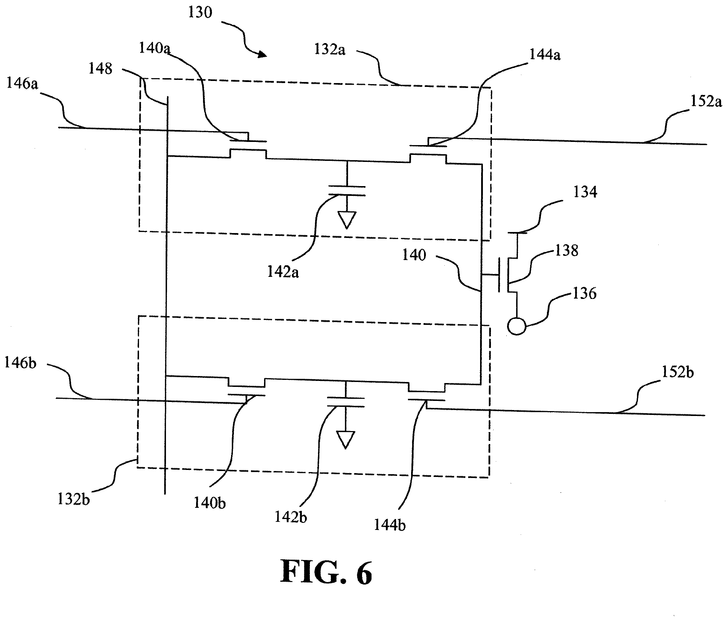

An active-matrix drive circuit 130, useful in such arrangements is shown in FIG. 6. As shown in this figure, this active-matrix drive circuit 130 controls the flow of current from a power line 134 to a node 136 representing the first electrode. Within the drive circuit 130, a drive transistor 138 controls the flow of current to node 136, based upon the voltage provided at the gate of this drive transistor 138. Within this drive circuit, the voltage to the gate of the drive transistor 138 is provided by a drive line 140 to either current control circuit 132a or current control circuit 132b; and either current control circuit 132a or current control circuit 132b provides a voltage to the drive transistor 138. Each of the current control circuits 132a, 132b includes a write transistor 140a, 140b; a storage element, specifically storage capacitors 142a, 142b, and a read transistor 144a, 144b.

During operation, a select signal is presented on one of the write lines 146a, 146b, placing a voltage on the gate of one of the write transistors 140a or 140b. This voltage activates the selected write transistor 140a or 140b, making the selected write transistor conducting. A data signal is provided on a data line 148 and passes through the selected write transistor 140a or 140b and charges the storage capacitor 142a or 142b that is connected to the selected write transistor 140a or 140b. The signal is then removed from the write line 146a or 146b and also subsequently from the data line 148. A signal is placed on the alternate of the write lines 146a or 146b, activating the second of the write transistors 140a or 140b. A data signal is placed on the data line 148 to charge the alternate of the storage capacitors 142a or 142b. Once again the signal is removed from the write line 146a, 146b. This process is repeated, providing both subsequent drive signals to the current control circuits 132a, 132b. Simultaneously, a select signal is alternately placed onto read lines 152a or 152b, permitting a voltage stored on the storage capacitors 142a, 142b to pass through the circuit and be presented on gate of the drive transistor 138 to control the flow of current from the power line 134 to the node 136. The capacitances of storage capacitors 142a, 142b are preferably much greater than the parasitic capacitance at the gate of the drive transistor 138 in order to reduce cross talk between storage capacitors 142a, 142b.

In the active-matrix circuit of FIG. 6, the read transistors 144a, 144b are switched at a rate that is higher than the rate at which the write transistors 140a, 140b are switched, permitting the write transistors 144a, 144b to be active for longer periods of time than the read transistors 140a, 140b. Therefore this drive circuit serves the function of a multiplexer which typically provides a control circuit to the drive transistor 138 in response to analog voltages, which are presented on the data line 148. Further, the multiplexer includes a drive transistor 138 connected to a first power supply and the first electrodes for regulating current from the power supply to the active areas of the light-emitting layer and a plurality of current control circuits 132a, 132b; each connected to a gate electrode of the drive transistor 138 and including a write transistor 140a, 140b, a storage capacitors 142a, 142b and a read transistor 144a, 144b.

It will be recognized by one skilled in the art that numerous drive circuits can be employed to provide the function of one or more multiplexers. For example, additional components are added to each or shared between the current control circuits 132a, 132b or the circuits can respond as a function of current rather than voltage. Further, certain simplifications of the drive circuit are possible. An alternate drive circuit is formed using a CMOS process, rather than an NMOS or PMOS process, any of which can be used to form the circuit shown in FIG. 4. However, in a CMOS device, the read transistor 144a is formed of a first doping, p or n, forming either a PMOS or NMOS TFT when the read transistor 144b is formed of a second doping, forming the alternate of the PMOS or NMOS TFT used to form the read transistor 144a. As such, read line 152a is attached to the gates of both read transistors 144a, 144b and a positive voltage is applied to read line 152a to select one of the current control circuits 140a or 140b for writing when a negative voltage is applied to the same read line 152a to select the other of the current control circuits 140a, 140b for reading, eliminating the need for read line 152b.

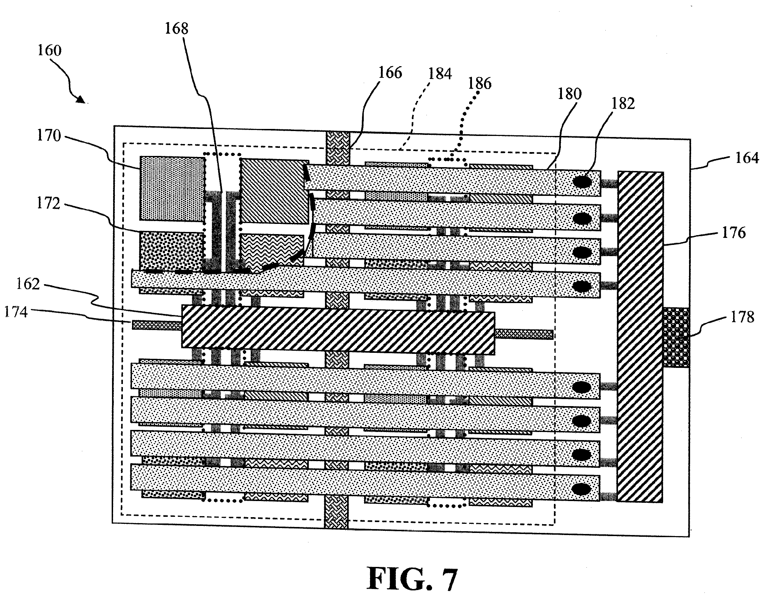

Although arrangements of the present invention can employ many different backplane technologies for supplying the drive circuits 30 (shown in FIG. 2), in one particularly advantaged arrangement, the active-matrix electroluminescent display further includes a chiplet formed on an independent chiplet substrate and attached to the display substrate, wherein one or more drive circuits are formed in the chiplet. For example, FIG. 7 shows a portion of a display panel 160 that includes a chiplet 162 mounted on a display substrate 164. This chiplet 162 contains, drive circuits, such as drive circuit 30, which modulates power between a power buss 166 and electrical leads 168 that are attached to first electrodes, including first electrodes 170, 172. Each chiplet 162 containing drive circuits will typically contain multiple drive circuits such that each chiplet 162 provides drive signals to multiple first electrodes 170, 172 however, the chiplets will typically contain a unique drive circuit for each first electrode 170, 172 to which it is attached. These chiplets will modulate the drive signals in response to signals provided on a signal line 174, which will typically be connected to a controller, such as controller 58 in FIG. 3.

A "chiplet" is a separately fabricated integrated circuit, which is mounted on the display substrate. Much like a conventional microchip (or chip) a chiplet is fabricated with a chiplet substrate and contains integrated transistors as well as insulator layers and conductor layers, which are deposited and then patterned using photolithographic methods in a semiconductor fabrication facility (or fab). These transistors in the chiplet are arranged in a transistor drive circuit to modulate electrical current to first electrodes 170, 172 of the present invention. The chiplet 162 is smaller than a traditional microchip and unlike traditional microchips; electrical connections are not made to a chiplet by wire bonding or flip-chip bonding. Instead, after mounting each chiplet onto the display substrate, deposition and photolithographic patterning of conductive layers and insulator layers are used to form the necessary attachments. Therefore, the connections are typically made small, for example through using vias 2 to 15 micrometers is size. This photolithographic patterning permits the first electrodes and the electrical leads 168 to be patterned of a single material, such as a metal layer.

Because the chiplets are fabricated in a traditional silicon fabrication facility, the semi-conductor within these chiplets is preferably crystalline, for example single crystal silicon, and are extremely stable, robust and have excellent electron mobility. As such, transistors formed within the chiplet for modulating the current to the first electrode are often very small. Circuits in the chiplet can respond to low voltage analog or digital control signals from a signal line 174 or other high frequency signal and modulates the flow of current from a power buss 166 to the first electrode 170, 172 in response to this control signal. In this architecture, the chiplets are capable of updating the signal to the first electrode 170, 172 in the electroluminescent display of the present invention several hundred times per second, permitting a display employing this arrangement to update every active area at a frequency of 60 Hz or more. This ability to update the signal to the drive transistor at this rate is especially advantageous within certain arrangements of the present invention. Further, memory units are formed within the chiplet and these memory units are used to store signals corresponding to different drive transistor values. As such it is possible for the chiplet to store values corresponding to multiple drive transistor values, permitting the chiplet to update the drive transistor values multiple times in response to a single control signal value, permitting the signal to the drive transistor to be updated at a rate that is faster than the rate at which the control signal is provided.

In some arrangements, CMOS sensors are also formed within these chiplets for detecting changes in light at each of these chiplets, providing an optical sensor within each chiplet. These chiplets can be employed with an optical layer of the present invention to be described in more detail shortly, to image the environment in which the electroluminescent display is located or employed for other uses, such as receiving an optically encoded control signal values.

Chiplets within the present arrangement can also be used to modulate power from a power connection or buss 178 to second electrodes 180. For example, chiplet 176 can modulate the power between these elements. It should be noted, however, that the power required on these cathode segments is often higher than traditional TFTs can provide. Therefore, the chiplets can contain another apparatus for modulating this power. For instance, the chiplet 176 can contain CMOS logic together with one or more microelectronic mechanical switches (MEMs) that serve as relays. Alternatively, the MEMs components can be provided in other structures that are commanded by the chiplet 176. It is important to note that within this configuration, each row of active areas defined by a single second electrode is activated or deactivated without activating or deactivating other active areas in the display. In the previous arrangement, the method for providing a high resolution display as shown in FIG. 5 simultaneously deactivated 112 all of the second electrodes. This deactivation can reduce the overall time for light emission from the panel and is more likely to provide images that appear to flicker than if deactivating all of the second electrodes was not required. By applying separate voltage control to each of the second electrodes as provided by the chiplets 176 on the display panel 160 in FIG. 7, simultaneously deactivating all of the second electrodes and therefore deactivating all of the active areas is no longer required. In this arrangement, only a single row of active areas needs to be deactivated or activated at any one time. This feature can reduce the likelihood that users will see flicker and other potential temporal image artifacts. Intermediate solutions are also possible wherein the chiplets 176 or other device controls multiple second electrodes simultaneously, without simultaneously activating or deactivating the respective second electrodes within each group of second electrodes as was described for the display panel 70 in FIG. 4. As shown in FIG. 7, the chiplet 176 will typically be mounted on the display substrate 164. Vias 182 can connect the chiplet 176 on the display substrate 164 to second electrodes 180 which are deposited over the electroluminescent layer 184, wherein the electroluminescent layer is deposited between the first 170, 172 and second electrodes 180. The display panel 160 will also typically contain an insulating layer 186 for preventing shorting of the electrical leads 168 to the second electrodes 180.

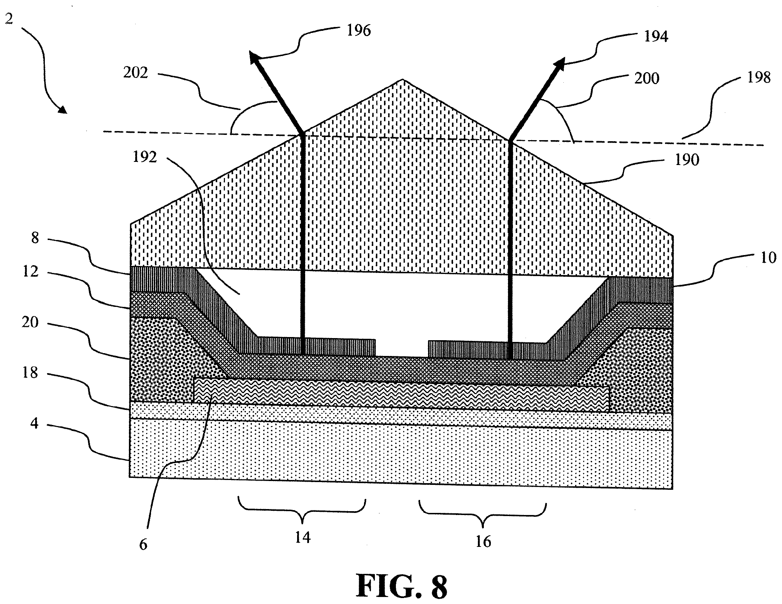

Specific arrangements of the present invention will include an optical layer, which includes an array of optical lens as shown in FIG. 8. As shown in this figure, the active-matrix electroluminescent display includes a display panel 2. This display panel includes a display substrate 4. At least a first electrode 6 is disposed over an area of the display substrate 4. Two or more individually-addressable, second electrodes 8, 10 are further disposed over the display substrate 4. An electroluminescent light-emitting layer 12 is formed between and in electrical contact with the first 6 and second 8, 10 electrodes to create two or more active areas 14,16 overlapping the first electrode, the light-emitting layer 12 emitting light within each active area 14, 16 in response to a current. The display panel 2 can optionally include an active matrix layer 18 and additional layers such as the pixel definition layer 20. Each of these features is the same as depicted in FIG. 1. However, the display panel 2 of FIG. 8 additionally includes an optical layer 190, which includes an array of optical lenses. An optical matching layer 192 can also be included to provide an index of refraction that is near the index of refraction of the EL light emitting layer 12 and the index of refraction of the optical layer 190. However, this optical matching layer 192 is not required and in certain arrangements, an inert gas or air is present between the second electrodes 8, 10 and the optical layer 190. The optical layer 190 will typically bend the light rays 194, 196 that are emitted within the active areas 14, 16 of the EL light emitting layer 12 such that the light emitted from within each of the active areas 14, 16 of the EL light emitting layer 12 are directed into different angles with respect to a plane parallel to the display substrate 4. As shown in FIG. 8, line 198 represents an imaginary plane that is parallel to a surface of the display substrate 4, and intersects a pair of light rays 194, 196 that are parallel to one another as they exit the EL light-emitting layer 12. However, as the light rays 194, 196 exit the optical layer 190 the angles 200, 202 of the two light rays 194, 196 with respect to the line 198, are different from one another, in this instance having different signs.

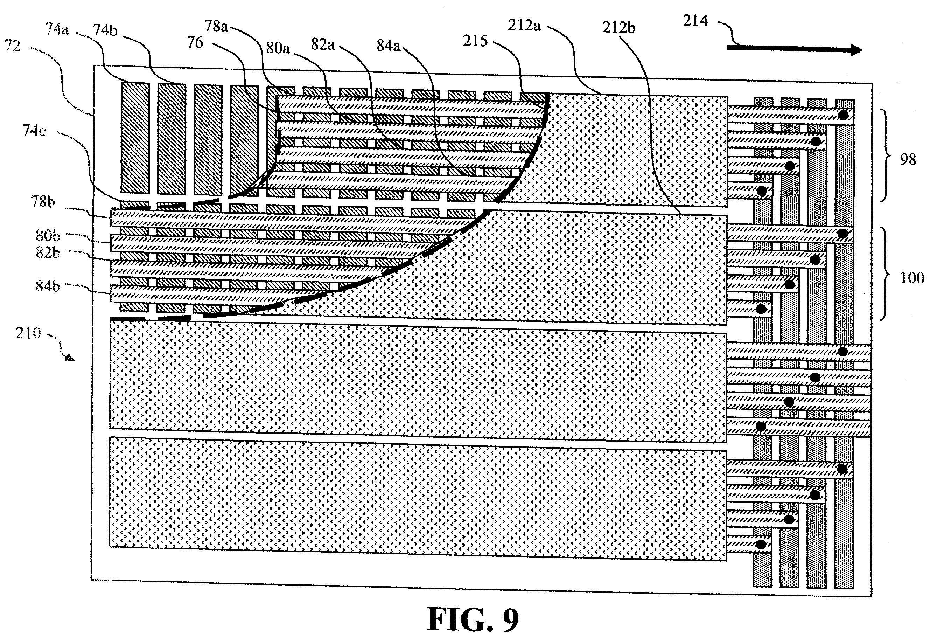

The optical layer 190 can include a two dimensional arrangement of structures or lenses to direct the light into different directions with respect to the display substrate 4. However, in certain arrangements, especially arrangements in which the second electrodes are separated into one dimensional stripes, it is desirable for the optical layer 190 to include an array of cylindrical optical lenses, each cylindrical lens having a long axis wherein the cylindrical lens magnifies the light produced by a light-emitting element in the electroluminescent display in the axis perpendicular to the long axis of the cylindrical lens. One example of such an arrangement is shown in FIG. 9. FIG. 9 shows a top view of display panel 210, having the optical layer 190 (as shown in FIG. 8) cut away along parting line 215 and the second electrodes 78a, 80a, 82a, 84a cut away along parting line 76. As shown, the optical layer 1 90 includes at least two cylindrical lenses 212a, 212b. These cylindrical lenses 212a, 212b have a long axis oriented parallel to a first dimension having a direction as indicated by the arrow 214. These cylindrical lenses 212a, 212b are arranged in an array and thus will magnify the light produced by an active area of the EL light-emitting layer. As shown, in FIG. 9, the display panel 210 includes a one dimensional array of second electrodes 80a, 80b, 82a, 82b, 84a, 84b, 86a, 86b arranged as one dimensional stripes having a long axis oriented parallel to the a first dimension, as indicated by the arrow 214, wherein the long axis of the one dimensional stripes of second electrodes 80a, 80b, 82a, 82b, 84a, 84b, 86a, 86b are aligned parallel to a long axis of the cylindrical lenses 212a, 212b. In this arrangement, the active-matrix electroluminescent display includes an array of optical lenses, wherein these optical lenses are cylindrical lenses. Each cylindrical lens has a long axis extending in the first direction, and each cylindrical lens is disposed over one or more second electrodes and magnifies the light produced in active areas corresponding to the one or more second electrodes. Further, each of the one or more second electrodes disposed under each cylindrical lens is connected to a different power supply circuit.

The cylindrical lenses 212a, 212b in FIG. 9 are cylindrical in that they have a shape, for example the triangular shape of the cross section of the optical layer 190 in FIG. 8 that is consistent along a long axis, as indicated by the arrow 214 in FIG. 9. Therefore by definition, a "cylindrical lens" refers to a portion of an optical material that has a feature that is long in a first axis as compared to a second axis and a cross section through the second axis is consistent along the first axis. By this definition, the cylindrical lens can have a cross section through the second axis that has the shape of a portion of a circle, a portion of an ellipse, a triangular shape or other shape.

As shown in FIG. 9, a desirable arrangement will include multiple second electrodes 80a, 82a, 84a, 86a under each cylindrical lens 212a and the display panel 210 will include a one-dimensional array of cylindrical lenses, wherein this one-dimensional array includes a plurality 212a, 212b of lenses. This array of lenses is individually attached to the other elements of the display panel 210 in some arrangements or formed within an optical substrate and this optical substrate attached to the display substrate 4 (shown in FIG. 8) of display panel 210.

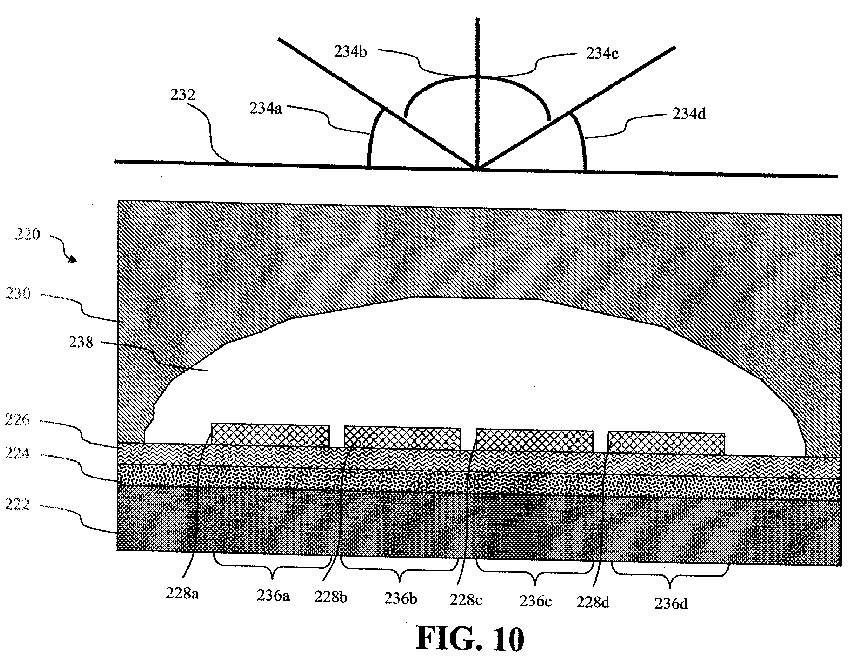

In this arrangement, the cylindrical lenses are shaped such that the light that is produced by the EL light-emitting layer in each active area defined by the overlap of the second electrodes, first electrodes and an EL light-emitting layer is projected within a given angle of view. FIG. 10 shows a portion of a display panel 220 of the present invention. As shown, the display panel 220 includes a display substrate 222, a first electrode 224, an EL light-emitting layer 226 and a plurality of second electrodes 228a, 228b, 228c, 228d, which define four active areas 236a, 236b, 236c, 236d. The optical layer 230 is then aligned to provide an optical lens over the first electrode 224 and the plurality of active areas 236a, 236b, 236c, and 236d. As shown, the function of the optical layer 230 is to direct the light produced within the active areas 236a, 236b, 236c, and 236d of the EL light-emitting layer 226 into four different viewing angles. To achieve this lens function the space 238 is filled with a material having a lower index of refraction than the optical layer 230. For example, at a plane 232 distant from the optical lens, the light from each of the active areas 236a, 236b, 236c, and 236d is directed into one of four different viewing angles, including a first viewing angle 234a, a second viewing angle 234b, a third viewing angle 234c, and a fourth viewing angle 234d. Notice that the viewing angles 234a, 234b, 234c, 234d are different from one another. These viewing angles 234a, 234b, 234c, 234d can differ by having center directions that are different from one another or their angular subtense is different from one another. In most arrangements of the present invention, the different viewing angles 234a, 234b, 234c, 234d will have different center directions and project light into cones that do not overlap by more than 80% of their total angular subtense. That is the point in the distribution of the light where the amplitude of the luminance is less than 5% of the peak luminance within any viewing angle will not overlap the same point on the neighboring viewing angle by more than 80% of the angular subtense of either of the two viewing angles. In arrangements employed for power reduction it is desirable that this overlap not be larger than 50%. In arrangements of the present invention to be employed as a stereoscopic display it is desirable that the overlap not be larger than 10%. Therefore, the light emitted within active area 236a is directed such that it is directed within angle 234a, the light emitted within active area 236b is directed into angle 234b, the light emitted within active area 236c is directed into angle 234c and the light emitted within active area 236d is directed into angle 234d.

Applying the display panel 220 within the EL, the controller 58 (shown in FIG. 3) can provide control signals to the power supply circuits 54, 56 to control the voltage to a subset of second electrodes 228a, 228b, 228c, 228d to activate a first subset of the second electrodes causing active areas 236a, 236b, 236c, and 236d of the light-emitting layer 226 associated with a first electrode 224 to produce light having a narrow viewing angle. That is, the controller 58 can provide control signals to the power supply circuits 54, 56 to deactivate a subset of the active areas, for example 236a, 236b, and 236d when providing control signals to other supply circuits 54, 56 to active a subset of the active areas, for example 236c. As such, the display panel will emit light into only viewing angle 234c. This arrangement is used to provide light with a narrow viewing angle and thereby reduce the power consumption of the display panel 220. That is, since only one of the active areas is emitting light in response to a drive signal provided to the first electrode 224, the power consumption of the display is reduced. In this example, the power consumed by the EL display is reduced by a factor equal to the number of activated active areas to the total number of active areas, e.g. by a factor of one fourth. However, as long as the user views the display from within the range of viewing angles 234c, the user will not see an appreciable change in the luminance or image quality of the display regardless of the number of activated active areas. Therefore, this feature can provide a display having a significantly reduced power without any change in the user's perception of the EL display.

Therefore, an active-matrix electroluminescent display having a high efficiency mode of operation is provided which includes a display substrate 222 (in FIG. 10), a two dimensional array of first electrodes 224 disposed over the display substrate 222. Two or more second electrodes 228a, 228b, 228c, 228d are also disposed over the display substrate 222. More specifically, two or more second electrodes 228a, 228b, 228c, 228d are disposed over each of the first electrodes within the two dimensional array of first electrodes 224. An electroluminescent light-emitting layer 226 is formed between and in electrical contact with the first 224 and second electrodes 228a, 228b, 228c, 228d within active areas 236a, 236b, 236c, and 236d. The light-emitting layer 226 emits light from each active area 236a, 236b, 236c, and 236d in response to a current between one of the first electrodes 236a in the two dimensional array of first electrodes and one of the two or more second electrodes 228a, 228b, 228c, 228d that are disposed over the first electrode 224. For instance, light will be emitted from the light-emitting layer 226 within active areas 236a as current flows between the second electrode 228a and first electrode 224. The active matrix display further includes a two-dimensional array of drive circuits 30, 130 (as shown in FIG. 2 or FIG. 6), each drive circuit including a drive transistor 32, 138 electrically connected to one of the first electrodes 224 in the two-dimensional array of first electrodes and wherein the two-dimensional array of drive circuits 30, 130 are in one to one correspondence with the two dimensional array of first electrodes and the drive circuits 30, 130 within the two-dimensional array of drive circuits provide a current to each of the first electrodes 224 within the two-dimensional array of first electrodes. Two or more power supply circuits 54, 56 (shown in FIG. 3) connected to respective second electrodes 228a, 228b, 228c, 228d for selectively supplying a voltage to the respective second electrodes 228a, 228b, 228c, 228d are also provided. An optical layer 230 of FIG. 10 is provided for directing the light emitted within each active area 236a, 236b, 236c, 236d of the electroluminescent light-emitting layer 226. The light from each active area 236a, 236b, 236c, 236d is directed into a different viewing angle. Finally, a controller 58 (shown in FIG. 3) is provided for receiving an input image signal 60 and a field of view signal 64 and providing a drive signal 62 to the two-dimensional array of drive circuits 30, 130 (shown in FIG. 2 and FIG. 6) in response to the input image signal 60 and sequentially or simultaneously causing the power supply circuits 54, 56 to provide the voltage to the respective second electrodes 228a, 228b, 228c, 228d in response to the field of view signal 64.

As described earlier, within this arrangement, it is desirable that the second electrodes be formed from an array of stripes 228a, 228b, 228c, 228d as depicted by the second electrodes 78a, 80a, 82a, 84a of FIG. 9, the long axis of the stripes oriented along a first dimension as indicated by arrow 214 and wherein the optical layer includes an array of cylindrical lenses 212a, 212b, the cylindrical lenses having a long axis, the long axis of the cylindrical lenses also oriented along the first dimension as indicated by arrow 214.

Within this particular arrangement, it is desirable that the first dimension is oriented along the horizontal axis of the display panel to permit only the vertical viewing angle of the display panel to be adjusted. However, it is also useful if the first dimension is oriented along the vertical axis of the display panel to permit the horizontal viewing angle of the display to be adjusted. Also, in the previous example, only one of the active areas was activated at any moment in time. This is not a requirement and any subset of the active areas is activated when the display is operated in the high efficiency mode of operation. The largest power savings and therefore the highest display power efficiency will be achieved when only one of the active areas is activated. It should also be noted that some arrangements of the EL display of the present invention require that the active areas be activated and deactivated multiple times per second; however, this is not a requirement in this particular arrangement. In fact, under typical operating conditions, the vertical viewing angle will likely be manually switched by a user one time every several minutes; therefore, it is certainly possible for this arrangement to be employed with any traditional backplane arrangement, regardless of the display size. That is, the drive circuits 30, 130 are formed using any semiconductor, including amorphous, polycrystalline or single crystal silicon as fast switching times are not required. It is also possible that other user input devices, including a head tracker, eye tracker or other such device capable of detecting the approximate location of the eyes of a user is used to produce the field of view signal 64 such that the field of view of the display panel is automatically adjusted as the user moves in front of the display panel. However, even in this example, the field of view will not be required to be updated at a rate of more than a few times per second.

As the active matrix EL display will have higher power efficiency when displaying images having a smaller viewing angle, the display is driven using a lower current when operating with a narrower viewing angle. Using the same drive circuit to provide a lower peak current can result in the loss of gray scale resolution. This issue is overcome by multiple configurations. In one configuration, the power supply circuits 54, 56 will be capable of switching between two voltage sources for providing an activation signal wherein one of the voltage sources provides a voltage more similar to the voltage of the peak voltage provided by the first electrode while the other provides a voltage less similar to the peak voltage provided by the first electrode. The voltage source having a voltage less similar to the peak voltage provided by the first electrode is applied when presenting images with a wide viewing angle and the voltage source which provides a voltage more similar to the voltage of the peak voltage provided by the first electrode is applied when presenting images with a narrow viewing angle. The range of data voltages provided on the data line 42 of FIG. 2 can also be adjusted as the display is switched from wide angle to narrow angle to provide improved bit depth.

In the previous arrangement a first subset of the active areas were activated and the remaining active areas were deactivated to provide an EL display having a narrow viewing angle. In another arrangement the first subset of active areas is activated to present an image having a narrow viewing angle within one time interval and a second subset of active areas are activated to present an image having a wider viewing angle within a second time interval. That is the controller will cause the power supply circuits to additionally activate a second subset of the second electrodes to produce light having a wider viewing angle. During these time intervals, the input image signal can include signals for forming multiple images, including at least a first image data and, in some instances, a second image data. These data are converted to drive signals that are provided to the two-dimensional array drive circuits within the display panel for displaying an image corresponding to the first or second image data. In this arrangement, the controller 58 (shown in FIG. 3) can provide control signals to the power supply circuits 54, 56 to control the voltage to the of second electrodes 228a. 228b, 228c, 228d (shown in FIG. 10) to activate a first subset of the active areas 236a, 236b, 236c, and 236d of the light-emitting layer 226 associated with a first electrode 224 to produce light having a narrow viewing angle within a first time interval. That is, within a first time interval, the controller 58 can provide control signals to the power supply circuits 54, 56 to deactivate a subset of the active areas, for example 236a, 236b, and 236d while providing control signals to other supply circuits 54, 56 to active a subset of the active areas, for example 236c. During this first time interval, the controller 58 can provide first image data to the drive circuits while causing the power supply circuits 54, 56 to activate a first subset of second electrodes to produce light. As such, the display panel will emit light corresponding to the first image data into only viewing angle 234c. However, in a subsequent time interval, the controller 58 (shown in FIG. 3) can provide control signals to the power supply circuits 54, 56 (shown in FIG. 3) to control the voltage to the of second electrodes 228a, 228b, 228c, 228d (shown in FIG. 10 to activate a second subset of the active areas 236a, 236b, 236c, and 236d of the light-emitting layer 226 associated with a first electrode 224 to produce light having a wider viewing angle. That is, in the second time interval, the controller 58 can provide control signals to the power supply circuits 54, 56 to active a second subset of the active areas, for example active areas 236a, 236b, 236c, and 236d. During this second time interval, the controller 58 can sequentially provide second image data to the drive circuits 54, 56 while causing the power supply circuits to activate a second subset of second electrodes to produce second light. As such, the display panel will emit light a wide viewing angle during a second time interval which corresponds to the second image data. When the first and second time intervals are short enough (e.g., less than 1/50^{th} of a second) and the two views are sequenced fast enough (e.g., each has a frequency of 50 Hz or faster), a first user viewing the image from within the viewing angle 234c will perceive an image that is the combination of the images presented during the first and second time intervals. If the drive circuit 30 is updated fast enough in response to two separate image signals, enabling the presentation of these two different image signals to a first and a second user, the first user will perceive the combination of two images without significant artifacts. However, a second user viewing the display from a different angle, for example 234b will only see one of the images and therefore receive different information than the first user. In this arrangement, the controller additionally provides control signals to the power supply circuits to activate the two second electrodes to additionally activate a second subset of the active areas of the light-emitting layer associated with a first electrode to produce light having a wider viewing angle. A possible advantage of this embodiment would be the presentation of information such as subtitles, which were observable by only some of the users. It should be noted, however that it is not necessary that the first and second image data be different or that the first light be different from the second light, other than having a different direction or angle of view.

In another arrangement the active-matrix EL display can provide two separate images into two separate viewing angles, for example 234b, and 234c using the same protocol of activating only a first active area 234b to provide a first image data having a first viewing angle 234b during a first interval of time and activating only a second active area 236c to provide a second image data having a second viewing angle 234c during a second interval of time. As in the previous arrangement, the signal provided to the first electrode 224 is updated based upon a change in the input image signal 60 (shown in FIG. 3) within each of the first and second time intervals to provide two separate images to two separate users who are viewing the display from the two separate viewing angles 234b, 234c. As such, the active-matrix electroluminescent display includes a controller 58 (as shown in FIG. 3), which provides a first set of control signals to the plurality of first and second circuits 54, 56 to cause selected active areas 236a, 236b, 236c, and 236d of the light-emitting layer 226 in electrical contact with the first electrode 224 to emit light oriented in a first direction and having a first narrow viewing angle 234b and a second set of control signals to the plurality of first and second circuits 54, 56 to cause selected active areas 236a, 236b, 236c, and 236d of the light-emitting layer 226 in electrical contact with the first electrode 224 to emit light oriented in a different second direction or having a different second narrow viewing angle 234c. Within this application, it is useful that the controller sequentially provides first image data to the drive circuits while causing the power supply circuits to activate a first subset of second electrodes to produce first light during a first time interval and sequentially provides second image data to the drive circuits while causing the power supply circuits to activate a second subset of second electrodes to produce second light during a second time interval.

This arrangement also useful to provide multiple views of a single scene, such as multiple viewer locations, as is useful in providing a stereoscopic or 3D image. In this arrangement, the active-matrix EL display, will further include a controller 58 (shown in FIG. 3) for receiving an input image signal 60 including multiple views of an individual scene, including at least first image data corresponding to a first view and a second image data corresponding to a second view of the scene. The active-matrix EL display is then controlled to present these views with different viewing angles, wherein the different viewing angles have different directions or different angular subtense. In this embodiment the controller provides a first drive signal to the drive circuit 30, 130 (shown in FIG. 2, 6) in response to the input image signal 60 during a first time interval while synchronously causing the power supply circuits 54, 56 (shown in FIG. 3) to provide a voltage to the respective second electrodes (228a, 228b, 228c, 228d) to cause one or more of the active areas 236a, 236b, 236c, 236d of the light-emitting layer 226 in electrical contact with the first electrode 224 to emit light oriented in a first direction and having a first narrow viewing angle 234a, 234b, 234c, 234d. The controller 58 (shown in FIG. 3) subsequently provides a second drive signal 62 (shown in FIG. 3) during a second time interval to the drive circuit 30 (shown in FIG. 2) in response to the input image signal 60 (shown in FIG. 3) while synchronously causing the power supply circuits 54, 56 (in FIG. 3) to provide a voltage to the respective second electrodes 228a, 228b, 228c, 228d to cause one or more of the active areas 236a, 236b, 236c, 236d of the light-emitting layer 226 in electrical contact with the first electrode 224 to emit light oriented in a second direction or having a second narrow viewing angle 234a, 234b, 234c, 234d.

In a display for providing a stereoscopic or multiview image, the cylindrical lens should be oriented vertically on the display panel. Additionally, it is desirable for the long axis of the second electrodes 228a, 228b, 228c, 228d to also be oriented vertically on the display panel. As described in this embodiment, the controller sequentially provides first image data to the drive circuits while causing the power supply circuits to activate a first subset of second electrodes to produce first light viewed by a user, and provides second image data to the drive circuits while causing the power supply circuits to activate a second subset of second electrodes to produce second light in a different direction than the first light and viewed by the user, whereby the user sees a stereoscopic image. However, to view a stereoscopic image, only two views are required. In embodiments for providing multiview stereoscopic images, larger number of views of the scene can be provided such that more than one user will see a stereoscopic image.

In a more specific arrangement, an active-matrix electroluminescent display for providing a plurality of images to a plurality of viewing angles is provided. This active-matrix electroluminescent display 50 (in FIG. 3) includes a display panel 220 (in FIG. 10). The display panel 220 includes a display substrate 222. A two dimensional array of first electrodes 224 are disposed over the display substrate 222. Two or more second electrodes 228a, 228b, 228c, 228d are also disposed over the display substrate 222. In this arrangement, two or more second electrodes 228a, 228b, 228c, 228d are disposed over each of the first electrodes 224 within the two dimensional array of first electrodes. An electroluminescent light-emitting layer 226 is formed between and in electrical contact with the both the first electrodes 224 in the array of first electrodes and the second electrodes 228a, 228b, 228c, 228d within active areas 236a, 236b, 236c, and 236d, the light-emitting layer 102 emitting light from each active area areas 236a, 236b, 236c, and 236d in response to a current between one of the first electrodes 224 in the two dimensional array of first electrodes and one of the two or more second electrodes 228a, 228b, 228c, 228d that are disposed over the first electrode 224c. A two-dimensional array of drive circuits (for example drive circuits 30 in FIG. 2), each drive circuit including a drive transistor 32 electrically connected to one of the first electrodes 224 in the two-dimensional array of first electrodes and wherein the two-dimensional array of drive circuits are in one to one correspondence with the two dimensional array of first electrodes and the drive circuits 30 within the two-dimensional array of drive circuits provide a current to each of the first electrodes 224 within the two-dimensional array of first electrodes. An electroluminescent light-emitting layer 226 is formed in each active area 236a, 236b, 236c, 236d between and in electrical contact with each of the first electrodes 224 in the two dimensional array of first electrodes and the second electrodes 228a, 228b, 228c, 228d, the light-emitting layer 226 emitting light from each active area 236a, 236b, 236c, 236d in response to the current from the drive transistor 32 (in FIG. 2). Two or more power supply circuits 54, 56 (shown in FIG. 3) are connected to respective second electrodes 228a, 228b, 228c, 228d for selectively supplying a voltage to the respective second electrodes 228a, 228b, 228c, 228d. A different power supply circuit 54, 56 (shown in FIG. 3) will typically be connected to each of the second electrodes 228a, 228b, 228c, 228d which overlap any one of the first electrodes. The display panel 230 will additionally include an optical layer 230 for directing the light emitted within each active area 236a, 236b, 236c, 236d of the electroluminescent light-emitting layer 226 to have a different direction and range of viewing angles 234a, 234b, 234c, 234d. The active-matrix electroluminescent display 50 (in FIG. 3) will further include a controller 58 (in FIG. 3) for receiving an input image signal 60 including a plurality of images; providing a first drive signal 62 to the two-dimensional array of drive circuits 30 (in FIG. 2) in response to the input image signal 60 and causing the power supply circuits 54, 56 to provide a voltage to a first (for example 228a) of the second electrodes 228a, 228b, 228c, 228d to cause the light-emitting layer 226 within a first group of active areas, including one of the active areas 228a, 228b, 228c, 228d associated with one of the first electrodes 224 within the array of electrodes and an active area associated with a second of the first electrodes 224 within the array of electrodes to emit light with a first direction and subtended angle 234a, 234b, 234c, 234d and providing a second drive signal 62 (in FIG. 3) to the two-dimensional array of drive circuits 30 (in FIG. 2) in response to the input image signal 60 (in FIG. 3) and causing the power supply circuits 54, 56 (in FIG. 3) to provide a voltage to a second, for example 236b of the second electrodes to cause the light-emitting layer 226 within a second, different group of active areas 228a, 228b, 228c, 228d associated with one of the first electrodes 224 within the array of electrodes and an active area associated with a second of the first electrodes 224 within the array of electrodes to emit light with a second direction or subtended angle 234a, 234b, 234c, 234d. The controller will provide a different drive signal 62 (in FIG. 3) to the two-dimensional array of drive circuits 30 (in FIG. 2) in response to each of the views within the input image signal while causing the power supply circuits 54, 56 (in FIG. 3) to provide a voltage to subsequent sets of second electrodes such that each of the views are presented in a different direction.

To present high quality images, the controller provides different drive signals to each of the drive circuits 30 within the two dimension array such that the drive signal to each of the drive circuits 30 is provided at a frequency of at least 50 Hz. Preferably, the controller will provide these different drive signals at a frequency of at least 60 Hz and more preferably a frequency of at least 80 Hz. In a preferred embodiment, the first and second directions are different and the active matrix EL display is a stereoscopic display. In another arrangement, the first subtended angle is a wide viewing angle and the second subtended angle is a relatively narrow viewing angle to permit the display to provide a common image to a wide viewing angle and a selected image to a narrow viewing angle.

In the embodiment where the display shows multi-view 3D images, it is desirable to reduce the cross-talk between sequentially shown images. The application of chiplets with memory, chiplets with very fast operation, or pixel circuits with analog memories (e.g. FIG. 6) will be advantaged as the time to change from one set of signals to another on the first set of electrodes and be very fast (Step 118 in FIG. 5).

Within the embodiments of the present invention, multiple second electrodes 8, 10 in FIG. 1 are formed typically on top of the EL light-emitting layer within the active matrix EL displays of the present invention. Formation of these multiple electrodes 8, 10 on top of an active matrix display are not known in the active matrix EL display art. However, these segments are formed using multiple methods. In one arrangement, the second electrodes are all deposited as a single sheet of material and then segmented using laser cutting or physical scribing. In another arrangement, pillars are formed on top of the first electrodes that have a large height to width ratio (i.e., a ratio greater than 1) and the material of the second electrodes is deposited over these pillars such that the pillars break the continuous film to form separate second electrodes 8, 10. In another arrangement, a continuous film is deposited and patterned using, photolithographic patterning techniques, such as those described by DeFranco et al. in "Photolithoghraphic patterning of Organic Electronic Materials" published in Organic Electronics 7 (2006) pgs. 21-28. In another arrangement, the separate second electrodes 8, 10 are individually printed using nozel, inkjet, or other printing technologies.

Within embodiments of the present invention, the first electrode and second electrodes are either the anode or the cathode. Either the first or second electrodes are formed nearest the display substrate. However, to permit the drive circuits to be readily attached to the first electrodes, the first electrodes will typically be formed on the display substrate. The light is emitted either through the display substrate or away from the display substrate. However, in arrangements employing an optical layer it is preferred that the light be emitted away from the display substrate, that the display substrate itself form the optical layer or that the display substrate have a thickness that is less than the width and height of the first electrodes as viewed in a top view (e.g. FIG. 4), as these conditions will permit the optical layer to focus the light within a desired viewing angle.

The optical layer 190 is formed from any materials that are capable of directing the light from separate second electrodes into separate viewing angles. In one arrangement, the optical layer is a fixed lenticular lens formed in a single substrate of glass or polymeric material. Such an embodiment is very low cost, however, the optical layer is always operational and as such, this layer precludes the display of a very high-resolution, two-dimensional image (i.e., an image having a resolution equal to the number of first electrodes multiplied by the number of second electrodes per first electrode) with a very wide viewing angle. In another embodiment, the optical layer 190 can include optical elements that have a variable optical power, including polarization-activated microlenses or active lenses as described by Woodgate and Harrold in the Society for Information Display Journal article entitled "Efficiency analysis of multi-view spatially multiplexed autostereoscopic 2-D/3D displays" (J of SID, 15/11 2007 pgs. 873-881). Similar active lenses are also described in Huang et al., in a paper entitled "High resolution autostereoscopic 3D display with scanning multi-electrode driving liquid crystal (MeD-LC) Lens" (SID 09, pgs. 336-339). These active lenses are activated with a fixed power and shape when an optical layer is desired to provide multiple views or power savings and deactivated to provide a very high resolution two-dimensional display with a wide viewing angle when multiple views or power savings is not required.

The present invention can be practiced in any active matrix EL display employing coatable, electroluminescent materials. In a preferred embodiment, the present invention includes electroluminescent layers composed of small-molecule or polymeric OLEDs as disclosed in, but not limited to U.S. Patent No. 4,769,292 to Tang et al., and U.S. Patent No. 5,061,569 to VanSlyke et al. The present invention can also be practiced in a device employing coatable inorganic layers including quantum dots formed in a polycrystalline semiconductor matrix, as taught in U.S. Patent Application Publication No. 2007/0057263 by Kahen, and employing an organic or inorganic semi-conductor matrix and charge-control layers. It will be appreciated by those skilled in the art that the EL light-emitting layer of the present invention will typically include multiple layers for charge injection, transport, and recombination. Further the EL light-emitting layer can include two or more devices operated in tandem with each device having a doped light-emission layer in which holes and electrons combine, resulting in the emission of light.

The present invention requires that the light-emitting layer be formed in electrical contact with the first electrode and multiple second electrodes. Further, light emission only occurs as an electrical potential is placed between a first electrode and a second electrode, promoting the flow of current through the light-emitting layer. Therefore, by modulating the voltage to either the cathode or the anode permits the localized control of light emission at a very high resolution when updated rapidly.

The invention has been described in detail with particular reference to certain preferred embodiments thereof.

### PARTS LIST

- 2: display panel
- 4: display substrate
- 6: first electrode
- 8: second electrode
- 10: second electrode
- 12: light-emitting layer
- 14: active area
- 16: active area
- 18: active matrix layer
- 20: pixel definition layer
- 30: drive circuit
- 32: drive transistor
- 34: power line
- 36: node
- 38: select line
- 40: data transistor
- 42: data line
- 44: capacitor
- 50: active matrix EL display
- 52: display panel
- 54: power supply circuit
- 56: power supply circuit
- 58: controller
- 60: input image signal
- 62: drive signal
- 64: field of view signal
- 70: display panel
- 72: display substrate
- 74a: first electrode
- 74b: first electrode
- 74c: first electrode
- 76: cutout
- 78a: second electrode
- 78b: second electrode
- 80a: second electrode
- 80b: second electrode
- 82a: second electrode
- 82b: second electrode
- 84a: second electrode
- 84b: second electrode
- 86: power buss
- 88: power buss
- 90: power buss
- 92: power buss
- 94: via
- 96: power leads
- 98: group of second electrodes
- 100: group of second electrodes
- 102: light-emitting layer
- 104a: active area
- 104b: active area
- 104c: active area
- 104d: active area
- 110: receive input image signal step
- 112: deactivate second electrodes step
- 114: select for deactivation step
- 116: select input image signal step
- 118: update drive signal step
- 120: activate active areas step
- 122: deactivate second electrodes step
- 124: select second electrodes step
- 130: active-matrix drive circuit
- 132a: current control circuit
- 132b: current control circuit
- 134: power line
- 136: node
- 138: drive transistor
- 140: drive line
- 140a: write transistor
- 140b: write transistor
- 142a: storage capacitor
- 142b: storage capacitor
- 144a: read transistor
- 144b: read transistor
- 146a: write line
- 146b: write line
- 148: data line
- 152a: read line
- 152b: read line
- 160: display panel
- 162: chiplet
- 164: display substrate
- 166: power buss
- 168: electrical leads
- 170: first electrode
- 172: first electrode
- 174: signal line
- 176: chiplet
- 178: power buss
- 180: second electrodes
- 182: via
- 184: light-emitting layer
- 186: insulating layer
- 190: optical layer
- 192: optical matching layer
- 194: light ray
- 196: light ray
- 198: line
- 200: angle
- 202: angle
- 210: display panel
- 212a: cylindrical lens
- 212b: cylindrical lens
- 214: arrow
- 215: parting line
- 220: display panel
- 222: display substrate
- 224: first electrode
- 226: EL light-emitting layer
- 228a: second electrode
- 228b: second electrode
- 228c: second electrode
- 228d: second electrode
- 230: optical layer
- 232: plane
- 234a: first viewing angle
- 234b: second viewing angle
- 234c: third viewing angle
- 234d: fourth viewing angle
- 236a: active area having a first viewing angle
- 236b: active area having second viewing angle
- 236c: active area having third viewing angle
- 236d: active area having fourth viewing angle
- 238: space

## Claims

1. An active-matrix electroluminescent display (50) comprising:
(a) a display substrate (222);
(b) a first electrode (224) disposed over the display substrate (222);
(c) two second electrodes (228a, 228b, 228c, 228d) disposed over the first electrode (224);
(d) an electroluminescent light-emitting layer (226) formed between and in electrical contact with the first (224) and second (228a, 228b, 228c, 228d) electrodes, so that first and second active areas (236a, 236b, 236c, 236d) are defined where the first electrode (224) and each respective second electrode (228a, 228b, 228c, 228d) overlap, the light-emitting layer (226) emitting light from each active area (236a, 236b, 236c, 236d) in response to current between the first (224) and each respective second electrode (228a, 228b, 228c, 228d);
(e) a drive circuit (30) including a drive transistor (32) electrically connected to the first electrode (224) for controlling the flow of current through the electroluminescent light-emitting layer (226);
(f) two power supply circuits (54, 56) connected to respective second electrodes (228a, 228b, 228c, 228d) for selectively providing respective voltages to the respective second electrodes (228a, 228b, 228c, 228d); and
(g) a controller (58) for sequentially or simultaneously causing the power supply circuits (54, 56) to provide the voltages to the respective second electrodes (228a, 228b, 228c, 228d),
each second electrode (228a, 228b, 228c, 228d) extends in a first direction, wherein the active-matrix electroluminescent display (50) further comprises an array of first electrodes (224) disposed over the display substrate (222), and an array of second electrodes (228a, 228b, 228c, 228d), wherein each of the second electrodes (228a, 228b, 228c, 228d) overlaps a plurality of first electrodes (224), and
**characterized in that** an optical layer (230) includes an array of optical lenses, wherein the optical lenses are cylindrical lenses (212a, 212b), each having a long axis extending in the first direction, and wherein each cylindrical lens is disposed over one or more second electrodes (228a, 228b, 228c, 228d) and is configured to magnify the light produced in active areas corresponding to the one or more second electrodes (228a, 228b, 228c, 228d), the optical layer (230) being configured to direct the light emitted within each active area (236a, 236b, 236c, 236d) of the electroluminescent light-emitting layer (226) to have a different direction and range of viewing angles (234a, 234b, 234c, 234d),
wherein each of the one or more second electrodes (228a, 228b, 228c, 228d) is connected to a different power supply circuit (54, 56), and
wherein the controller (58) is configured to sequentially provide first image data to the drive circuits while causing the power supply circuits (54, 56) to activate a first subset of second electrodes (228a, 228b, 228c, 228d) to produce first light viewed by a user, and provide second image data to the drive circuits while causing the power supply circuits (54, 56) to activate a second subset of second electrodes (228a, 228b, 228c, 228d) to produce second light in a different direction than the first light.

2. The active-matrix electroluminescent display (50) of claim 1, further including a plurality of identical groups of second electrodes (228a, 228b, 228c, 228d), with each group overlapping a plurality of corresponding first electrodes (224) arranged along the first direction and wherein each second electrode within each group of second electrodes (228a, 228b, 228c, 228d) is electrically connected to corresponding second electrodes within each group of second electrodes (228a, 228b, 228c, 228d) and to a different power supply circuit (54, 56).

3. The active-matrix electroluminescent display (50) of claim 1, wherein the controller (58) is configured to cause the power supply circuits (54, 56) to simultaneously provide different voltages to the respective second electrodes (228a, 228b, 228c, 228d).

4. The active-matrix electroluminescent display (50) of claim 1, wherein the controller (58) is configured to cause the power supply circuits (54, 56) to simultaneously provide a first voltage to one of the second electrodes (228a, 228b, 228c, 228d) and disconnect the other second electrode (228a, 228b, 228c, 228d).

5. The active-matrix electroluminescent display (50) of claim 1, wherein the controller (58) is configured to additionally receive an input image signal and provide a first drive signal to the drive circuit (30) synchronously with causing the power supply circuits (54, 56)to provide the voltage to the respective second electrodes (228a, 228b, 228c, 228d).

6. The active-matrix electroluminescent display (50) of claim 5, wherein the drive circuit (30) is configured to receive and store the first drive signal during a first display update cycle and provide the signal to the first electrode (224) during a second display update cycle.

7. The active-matrix electroluminescent display (50) of claim 5, wherein the controller (58) is configured to sequentially provide a first subset of the input image signal to the drive circuit (30) and cause the power supply circuits (54, 56) to activate a first subset of second electrodes (228a, 228b, 228c, 228d) to produce first light during a first time interval and provide a second subset of the input image signal to the drive circuit (30) and cause the power supply circuits (54, 56) to activate a second subset of second electrodes (228a, 228b, 228c, 228d) to produce second light during a second time interval, whereby a user sees a high resolution display.

8. The active-matrix electroluminescent display (50) of claim 1, further including a chiplet (160) having an independent chiplet substrate attached to the display substrate (4), wherein the drive circuit is formed in the chiplet (160).

9. The active-matrix electroluminescent display (50) of claim 1, wherein the controller (58) is configured to cause the power supply circuits (54, 56) to activate a first subset of the second electrodes (228a, 228b, 228c, 228d).

10. The active-matrix electroluminescent display (50) of claim 9, wherein the controller (58) is configured to cause the power supply circuits (54, 56) to additionally activate a second subset of the second electrodes (228a, 228b, 228c, 228d).

11. The active-matrix electroluminescent display (50) of claim 1, wherein the controller (58) is configured to provides first image data to the drive circuits (30) while causing the power supply circuits (54, 56) to activate a first subset of second electrodes (228a, 228b, 228c, 228d) to produce first light.

12. The active-matrix electroluminescent display (50) of claim 11, wherein the controller (58) is configured to sequentially provide second image data to the drive circuits (30) while causing the power supply circuits (54, 56) to activate a second subset of second electrodes (228a, 228b, 228c, 228d) to produce second light.

13. The active-matrix electroluminescent display (50) of claim 12, wherein the first and second image data are each provided at a frequency of at least 50 Hz.

## Patentansprüche

1. Aktivmatrix-Elektrolumineszenzanzeige (50), umfassend:
(a) ein Anzeigesubstrat (222);
(b) eine erste Elektrode (224), die über dem Anzeigesubstrat (222) angeordnet ist;
(c) zwei zweite Elektroden (228a, 228b, 228c, 228d), die über der ersten Elektrode (224) angeordnet sind;
(d) eine Licht emittierende Elektrolumineszenzschicht (226), die zwischen und in elektrischem Kontakt mit der ersten Elektrode (224) und den zweiten Elektroden (228a, 228b, 228c, 228d) gebildet ist, sodass erste und zweite aktive Bereiche (236a, 236b, 236c, 236d) definiert sind, an denen die erste Elektrode (224) und jede jeweilige zweite Elektrode (228a, 228b, 228c, 228d) überlappen, wobei die Licht emittierende Schicht (226) als Reaktion auf einen Strom zwischen der ersten (224) und jeder jeweiligen zweiten Elektrode (228a, 228b, 228c, 228d) Licht von jedem aktiven Bereich emittiert;
(e) einen Ansteuerungsschaltkreis (30), der einen Ansteuerungstransistor (32) enthält, der elektrisch mit der ersten Elektrode (224) verbunden ist, um den Stromfluss durch die Licht emittierende Elektrolumineszenzschicht (226) zu steuern;
(f) zwei Energieversorgungsschaltkreise (54, 56), die mit den jeweiligen zweiten Elektroden (228a, 228b, 228c, 228d) verbunden sind, um den jeweiligen zweiten Elektroden (228a, 228b, 228c, 228d) selektiv jeweilige Spannungen zu liefern; und
(g) eine Steuerung (58) zum sequenziellen oder gleichzeitigen Bewirken, dass die Energieversorgungsschaltkreise (54, 56) den jeweiligen zweiten Elektroden (228a, 228b, 228c, 228d) die Spannungen liefern,
wobei jede zweite Elektrode (228a, 228b, 228c, 228d) in eine erste Richtung verläuft, wobei die Aktivmatrix-Elektrolumineszenzanzeige (50) ferner eine Anordnung von ersten Elektroden (224), die über dem Anzeigesubstrat (222) angeordnet sind, und eine Anordnung von zweiten Elektroden (228a, 228b, 228c, 228d) umfasst, wobei jede der zweiten Elektroden (228a, 228b, 228c, 228d) eine Mehrzahl der ersten Elektroden (224) überlappt, und
**dadurch gekennzeichnet, dass** eine optische Schicht (230) eine optische Linsenanordnung enthält, wobei die optischen Linsen Zylinderlinsen (212a, 212b) sind, die jeweils eine Längsachse aufweisen, die in die erste Richtung verläuft,
und wobei jede Zylinderlinse über einer oder mehreren zweiten Elektroden (228a, 228b, 228c, 228d) angeordnet ist und ausgelegt ist, das in der einen oder den mehreren zweiten Elektroden (228a, 228b, 228c, 228d) entsprechenden aktiven Bereichen erzeugte Licht zu verstärken, wobei die optische Schicht (230) ausgelegt ist, das innerhalb jedes aktiven Bereichs (236a, 236b, 236c, 236d) der Licht emittierenden Elektrolumineszenzschicht (226) emittierte Licht so zu lenken, dass es eine unterschiedliche Richtung und einen Bereich an Sichtwinkeln (234a, 234b, 234c, 234d) aufweist,
wobei jede der einen oder der mehreren zweiten Elektroden (228a, 228b, 228c, 228d) mit einem unterschiedlichen Energieversorgungsschaltkreis (54, 56) verbunden ist, und
wobei die Steuerung (58) ausgelegt ist, den Ansteuerungsschaltkreisen sequenziell erste Bilddaten zu liefern, während sie gleichzeitig bewirkt, dass die Energieversorgungsschaltkreise (54, 56) eine erste Teilmenge der zweiten Elektroden (228a, 228b, 228c, 228d) aktivieren, um von einem Benutzer betrachtetes erstes Licht zu erzeugen, und den Ansteuerungsschaltkreisen zweite Bilddaten zu liefern, während sie gleichzeitig bewirkt, dass die Energieversorgungsschaltkreise (54, 56) eine zweite Teilmenge der zweiten Elektroden (228a, 228b, 228c, 228d) aktivieren, um zweites Licht in einer vom ersten Licht verschiedenen Richtung zu erzeugen.

2. Aktivmatrix-Elektrolumineszenzanzeige (50) nach Anspruch 1, die ferner eine Mehrzahl an identischen Gruppen von zweiten Elektroden (228a, 228b, 228c, 228d) enthält, wobei jede Gruppe eine Mehrzahl von entsprechenden ersten Elektroden (224) überlappt, die entlang der ersten Richtung angeordnet sind, und wobei jede zweite Elektrode in jeder Gruppe der zweiten Elektroden (228a, 228b, 228c, 228d) mit entsprechenden zweiten Elektroden in jeder Gruppe der zweiten Elektroden (228a, 228b, 228c, 228d) und mit einem unterschiedlichen Energieversorgungsschaltkreis (54, 56) elektrisch verbunden ist.

3. Aktivmatrix-Elektrolumineszenzanzeige (50) nach Anspruch 1, wobei die Steuerung (58) ausgelegt ist, zu bewirken, dass die Energieversorgungsschaltkreise (54, 56) den jeweiligen zweiten Elektroden (228a, 228b, 228c, 228d) gleichzeitig unterschiedliche Spannungen liefern.

4. Aktivmatrix-Elektrolumineszenzanzeige (50) nach Anspruch 1, wobei die Steuerung (58) ausgelegt ist, zu bewirken, dass die Energieversorgungsschaltkreise (54, 56) gleichzeitig eine der zweiten Elektroden (228a, 228b, 228c, 228d) mit einer ersten Spannung versorgen und die Verbindung zu den anderen zweiten Elektroden (228a, 228b, 228c, 228d) trennen.

5. Aktivmatrix-Elektrolumineszenzanzeige (50) nach Anspruch 1, wobei die Steuerung (58) ausgelegt ist, zusätzlich ein Eingangsbildsignal zu empfangen und dem Ansteuerungsschaltkreis (30) ein erstes Ansteuerungssignal synchron mit einem Bewirken zu liefern, dass die Energieversorgungsschaltkreise (54, 56) den jeweiligen zweiten Elektroden (228a, 228b, 228c, 228d) die Spannung liefern.

6. Aktivmatrix-Elektrolumineszenzanzeige (50) nach Anspruch 5, wobei der Ansteuerungsschaltkreis (30) ausgelegt ist, das erste Ansteuerungssignal während eines ersten Anzeigeaktualisierungszyklus zu empfangen und zu speichern und der ersten Elektrode (224) das Signal während eines zweiten Anzeigeaktualisierungszyklus zu liefern.

7. Aktivmatrix-Elektrolumineszenzanzeige (50) nach Anspruch 5, wobei die Steuerung (58) ausgelegt ist, sequenziell dem Ansteuerungsschaltkreis (30) eine erste Teilmenge des Eingangsbildsignals zu liefern und zu bewirken, dass die Energieversorgungsschaltkreise (54, 56) eine erste Teilmenge der zweiten Elektroden (228a, 228b, 228c, 228d) aktivieren, um während eines ersten Zeitintervalls erstes Licht zu erzeugen, und dem Ansteuerungsschaltkreis (30) eine zweite Teilmenge des Eingangsbildsignals zu liefern und zu bewirken, dass die Energieversorgungsschaltkreise (54, 56) eine zweite Teilmenge der zweiten Elektroden (228a, 228b, 228c, 228d) aktivieren, um während eines zweiten Zeitintervalls zweites Licht zu erzeugen, wodurch ein Benutzer eine Anzeige mit hoher Auflösung sieht.

8. Aktivmatrix-Elektrolumineszenzanzeige (50) nach Anspruch 1, die ferner ein Chiplet (160) mit einem unabhängigen Chipletsubstrat enthält, das am Anzeigesubstrat (4) befestigt ist, wobei der Ansteuerungsschaltkreis im Chiplet (160) gebildet ist.

9. Aktivmatrix-Elektrolumineszenzanzeige (50) nach Anspruch 1, wobei die Steuerung (58) ausgelegt ist, zu bewirken, dass die Energieversorgungsschaltkreise (54, 56) eine erste Teilmenge der zweiten Elektroden (228a, 228b, 228c, 228d) aktivieren.

10. Aktivmatrix-Elektrolumineszenzanzeige (50) nach Anspruch 9, wobei die Steuerung (58) ausgelegt ist, zu bewirken, dass die Energieversorgungsschaltkreise (54, 56) zusätzlich eine zweite Teilmenge der zweiten Elektroden (228a, 228b, 228c, 228d) aktivieren.

11. Aktivmatrix-Elektrolumineszenzanzeige (50) nach Anspruch 1, wobei die Steuerung (58) ausgelegt ist, den Ansteuerungsschaltkreisen (30) erste Bilddaten bei gleichzeitigem Bewirken zu liefern, dass die Energieversorgungsschaltkreise (54, 56) eine erste Teilmenge der zweiten Elektroden (228a, 228b, 228c, 228d) aktivieren, um erstes Licht zu erzeugen.

12. Aktivmatrix-Elektrolumineszenzanzeige (50) nach Anspruch 11, wobei die Steuerung (58) ausgelegt ist, sequenziell den Ansteuerungsschaltkreisen (30) zweite Bilddaten bei gleichzeitigem Bewirken zu liefern, dass die Energieversorgungsschaltkreise (54, 56) eine zweite Teilmenge der zweiten Elektroden (228a, 228b, 228c, 228d) aktivieren, um zweites Licht zu erzeugen.

13. Aktivmatrix-Elektrolumineszenzanzeige (50) nach Anspruch 12, wobei die ersten und die zweiten Bilddaten jeweils mit einer Frequenz von mindestens 50 Hz geliefert werden.

## Revendications

1. Dispositif d'affichage électroluminescent à matrice active (50) comprenant :
(a) un substrat d'affichage (222) ;
(b) une première électrode (224) disposée sur le substrat d'affichage (222) ;
(c) deux secondes électrodes (228a, 228b, 228c, 228d) disposées sur la première électrode (224) ;
(d) une couche d'émission de lumière électroluminescente (226) formée entre et en contact électrique avec les première (224) et secondes (228a, 228b, 228c, 228d) électrodes, de telle sorte que des première et seconde zones actives (236a, 236b, 236c, 236d) sont définies aux endroits où la première électrode (224) et chaque seconde électrode (228a, 228b, 228c, 228d) respective se chevauchent, la couche d'émission de lumière (226) émettant une lumière à partir de chaque zone active (236a, 236b, 236c, 236d) en réponse à un courant entre la première (224) et chaque seconde électrode (228a, 228b, 228c, 228d) respective ;
(e) un circuit d'attaque (30) comprenant un transistor d'attaque (32) connecté électriquement à la première électrode (224) pour commander le flux de courant à travers la couche d'émission de lumière électroluminescente (226) ;
(f) deux circuits d'alimentation électrique (54, 56) connectés à des secondes électrodes (228a, 228b, 228c, 228d) respectives pour fournir de manière sélective des tensions respectives aux secondes électrodes (228a, 228b, 228c, 228d) respectives ; et
(g) un dispositif de commande (58) pour amener séquentiellement ou simultanément les circuits d'alimentation électrique (54, 56) à fournir les tensions aux secondes électrodes (228a, 228b, 228c, 228d) respectives,
chaque seconde électrode (228a, 228b, 228c, 228d) s'étendant dans une première direction, le dispositif d'affichage électroluminescent à matrice active (50) comprenant en outre un réseau de premières électrodes (224) disposées sur le substrat d'affichage (222), et un réseau de secondes électrodes (228a, 228b, 228c, 228d), chacune des secondes électrodes (228a, 228b, 228c, 228d) chevauchant une pluralité de premières électrodes (224), et
**caractérisé par le fait qu'**une couche optique (230) comprend un réseau de lentilles optiques, les lentilles optiques étant des lentilles cylindriques (212a, 212b), ayant chacune un axe long s'étendant dans la première direction, et chaque lentille cylindrique étant disposée sur une ou plusieurs secondes électrodes (228a, 228b, 228c, 228d) et étant configurée pour amplifier la lumière produite dans des zones actives correspondant à la ou aux secondes électrodes (228a, 228b, 228c, 228d), la couche optique (230) étant configurée pour diriger la lumière émise dans chaque zone active (236a, 236b, 236c, 236d) de la couche d'émission de lumière électroluminescente (226) pour avoir une direction différente et une plage d'angles de visualisation (234a, 234b, 234c, 234d) différente,
chacune de la ou des secondes électrodes (228a, 228b, 228c, 228d) étant connectée à un circuit d'alimentation électrique (54, 56) différent, et
le dispositif de commande (58) étant configuré pour fournir séquentiellement des premières données d'image aux circuits d'attaque tout en amenant les circuits d'alimentation électrique (54, 56) à activer un premier sous-ensemble de secondes électrodes (228a, 228b, 228c, 228d) pour produire une première lumière visualisée par un utilisateur, et fournir des secondes données d'image aux circuits d'attaque tout en amenant les circuits d'alimentation électrique (54, 56) à activer un second sous-ensemble de secondes électrodes (228a, 228b, 228c, 228d) pour produire une seconde lumière dans une direction différente de celle de la première lumière.

2. Dispositif d'affichage électroluminescent à matrice active (50) selon la revendication 1, comprenant en outre une pluralité de groupes identiques de secondes électrodes (228a, 228b, 228c, 228d), chaque groupe chevauchant une pluralité de premières électrodes (224) correspondantes agencées le long de la première direction et chaque seconde électrode dans chaque groupe de secondes électrodes (228a, 228b, 228c, 228d) étant connectée électriquement à des secondes électrodes correspondantes dans chaque groupe de secondes électrodes (228a, 228b, 228c, 228d) et à un circuit d'alimentation électrique (54, 56) différent.

3. Dispositif d'affichage électroluminescent à matrice active (50) selon la revendication 1, dans lequel le dispositif de commande (58) est configuré pour amener les circuits d'alimentation électrique (54, 56) à fournir simultanément différentes tensions aux secondes électrodes (228a, 228b, 228c, 228d) respectives.

4. Dispositif d'affichage électroluminescent à matrice active (50) selon la revendication 1, dans lequel le dispositif de commande (58) est configuré pour amener les circuits d'alimentation électrique (54, 56) à fournir simultanément une première tension à l'une des secondes électrodes (228a, 228b, 228c, 228d) et déconnecter l'autre seconde électrode (228a, 228b, 228c, 228d).

5. Dispositif d'affichage électroluminescent à matrice active (50) selon la revendication 1, dans lequel le dispositif de commande (58) est configuré pour recevoir en outre un signal d'image d'entrée et fournir un premier signal d'attaque au circuit d'attaque (30) de manière synchrone avec l'opération consistant à amener les circuits d'alimentation électrique (54, 56) à fournir la tension aux secondes électrodes (228a, 228b, 228c, 228d) respectives.

6. Dispositif d'affichage électroluminescent à matrice active (50) selon la revendication 5, dans lequel le circuit d'attaque (30) est configuré pour recevoir et stocker le premier signal d'attaque durant un premier cycle de mise à jour d'affichage et fournir le signal à la première électrode (224) durant un second cycle de mise à jour d'affichage.

7. Dispositif d'affichage électroluminescent à matrice active (50) selon la revendication 5, dans lequel le dispositif de commande (58) est configuré pour fournir séquentiellement un premier sous-ensemble du signal d'image d'entrée au circuit d'attaque (30) et amener les circuits d'alimentation électrique (54, 56) à activer un premier sous-ensemble de secondes électrodes (228a, 228b, 228c, 228d) pour produire une première lumière durant un premier intervalle de temps et fournir un second sous-ensemble du signal d'image d'entrée au circuit d'attaque (30) et amener les circuits d'alimentation électrique (54, 56) à activer un second sous-ensemble de secondes électrodes (228a, 228b, 228c, 228d) pour produire une seconde lumière durant un second intervalle de temps, moyennant quoi un utilisateur voit un dispositif d'affichage à haute résolution.

8. Dispositif d'affichage électroluminescent à matrice active (50) selon la revendication 1, comprenant en outre une micropuce (160) ayant un substrat de micropuce indépendant fixé au substrat d'affichage (4), le circuit d'attaque étant formé dans la micropuce (160).

9. Dispositif d'affichage électroluminescent à matrice active (50) selon la revendication 1, dans lequel le dispositif de commande (58) est configuré pour amener les circuits d'alimentation électrique (54, 56) à activer un premier sous-ensemble des secondes électrodes (228a, 228b, 228c, 228d).

10. Dispositif d'affichage électroluminescent à matrice active (50) selon la revendication 9, dans lequel le dispositif de commande (58) est configuré pour amener les circuits d'alimentation électrique (54, 56) à activer en outre un second sous-ensemble des secondes électrodes (228a, 228b, 228c, 228d).

11. Dispositif d'affichage électroluminescent à matrice active (50) selon la revendication 1, dans lequel le dispositif de commande (58) est configuré pour fournir des premières données d'image aux circuits d'attaque (30) tout en amenant les circuits d'alimentation électrique (54, 56) à activer un premier sous-ensemble de secondes électrodes (228a, 228b, 228c, 228d) pour produire une première lumière.

12. Dispositif d'affichage électroluminescent à matrice active (50) selon la revendication 11, dans lequel le dispositif de commande (58) est configuré pour fournir séquentiellement des secondes données d'image aux circuits d'attaque (30) tout en amenant les circuits d'alimentation électrique (54, 56) à activer un second sous-ensemble de secondes électrodes (228a, 228b, 228c, 228d) pour produire une seconde lumière.

13. Dispositif d'affichage électroluminescent à matrice active (50) selon la revendication 12, dans lequel les premières et secondes données d'image sont fournies chacune à une fréquence d'au moins 50 Hz.
